# EUROPÄISCHE PATENTSCHRIFT

(11) **EP 2 643 497 B1**
(45) Veröffentlichungstag und Bekanntmachung des Hinweises auf die Patenterteilung: **12.09.2018**
(21) Anmeldenummer: 11791506.6
(22) Anmeldetag: 23.11.2011
(51) Int. Cl.: C23C 18/14

(54) **VERFAHREN ZUR HERSTELLUNG VON METALLISCHEN STRUKTUREN**
PROCESS FOR PRODUCING METALLIC STRUCTURES
PROCÉDÉ DE PRODUCTION DE STRUCTURES MÉTALLIQUES

(30) Priorität: 23.11.2010 DE 102010052032
(43) Veröffentlichungstag der Anmeldung: 02.10.2013
(73) Patentinhaber: Leibniz-Institut für Neue Materialien gemeinnützige GmbH, 66123 Saarbrücken (DE)
(72) Erfinder: MOH, Karsten, 66440 Blieskastel-Brenschelbach (DE); DE OLIVEIRA, Peter William, 66123 Saarbrücken (DE); SCHUMACHER, Sarah, 66129 Saarbrücken (DE); ARZT, Eduard, 66123 Saarbrücken (DE)
(74) Vertreter: Patentanwälte Gierlich & Pischitzis Partnerschaft mbB
(86) Internationale Anmeldenummer: PCT/EP2011/070857
(87) Internationale Veröffentlichungsnummer: WO 2012/069552

(56) Entgegenhaltungen:
- US-A1- 2009 269 510
- DAN LI ET AL: "Photocatalytic deposition of gold nanoparticles on electrospun nanofibers of titania", CHEMICAL PHYSICS LETTERS, Bd. 394, Nr. 4-6, 1. August 2004 (2004-08-01), Seiten 387-391, XP55014340, ISSN: 0009-2614, DOI: 10.1016/j.cplett.2004.07.044
- XIN HE ET AL: "Studies on a possible growth mechanism of silver nanoparticles loaded on TiO2 thin films by photoinduced deposition method", JOURNAL OF NON-CRYSTALLINE SOLIDS, Bd. 354, Nr. 12-13, 1. Februar 2008 (2008-02-01), Seiten 1267-1271, XP55028505, ISSN: 0022-3093, DOI: 10.1016/j.jnoncrysol.2006.11.037
- QIAN WANG ET AL: "ZnO/Au Hybrid Nanoarchitectures: Wet-Chemical Synthesis and Structurally Enhanced Photocatalytic Performance", ENVIRONMENTAL SCIENCE & TECHNOLOGY, Bd. 43, Nr. 23, 1. Dezember 2009 (2009-12-01), Seiten 8968-8973, XP55028694, ISSN: 0013-936X, DOI: 10.1021/es902568h
- JIA H ET AL: "Nonaqueous sol-gel synthesis and growth mechanism of single crystalline TiO2 nanorods with high photocatalytic activity", MATERIALS RESEARCH BULLETIN, ELSEVIER, KIDLINGTON, GB, Bd. 44, Nr. 6, 3. Juni 2009 (2009-06-03), Seiten 1312-1316, XP026038613, ISSN: 0025-5408, DOI: 10.1016/J.MATERRESBULL.2008.12.016 [gefunden am 2009-01-08]
- P. DAVIDE COZZOLI ET AL: "Photocatalytic Synthesis of Silver Nanoparticles Stabilized by TiO 2 Nanorods: A Semiconductor/Metal Nanocomposite in Homogeneous Nonpolar Solution", JOURNAL OF THE AMERICAN CHEMICAL SOCIETY, Bd. 126, Nr. 12, 1. März 2004 (2004-03-01) , Seiten 3868-3879, XP55028509, ISSN: 0002-7863, DOI: 10.1021/ja0395846
- XINMEI ZHAO ET AL: "Monitoring catalytic degradation of dye molecules on silver-coated ZnO nanowire arrays by surface-enhanced Raman spectroscopy", JOURNAL OF MATERIALS CHEMISTRY, Bd. 19, Nr. 31, 1. Januar 2009 (2009-01-01), Seite 5547, XP55028691, ISSN: 0959-9428, DOI: 10.1039/b902883h

## Beschreibung

### Gebiet der Erfindung

Die Erfindung betrifft ein Verfahren zur Herstellung von metallischen, insbesondere leitfähigen Strukturen, sowie solche Substrate und ihre Verwendung.

### Stand der Technik

US 5,534,312 beschreibt eine Methode zur Herstellung einer metallischen Struktur durch Auftragen eines lichtempfindlichen Metallkomplexes auf ein Substrat und seine Zersetzung durch Bestrahlung. Dieses Verfahren ist kompliziert, da ein lichtempfindlicher Komplex gehandhabt werden muss. Außerdem entstehen üblicherweise Metalloxide, welche in einem weiteren Schritt mit Wasserstoff bei hohen Temperaturen von meistens über 200 °C zu den Metallen reduziert werden müssen.

Die Schrift US 2004/0026258 A1 beschreibt ein Verfahren, bei dem zunächst eine Mikrostruktur auf einem Substrat erzeugt wird. Diese Strukturen dienen als Keime für einen weiteren elektrolytischen Abscheidungsprozess. Auch in diesem Verfahren ist neben dem Abscheidungsprozess ein Reduktionsschritt erforderlich.

US 2005/0023957 A1 beschreibt die Herstellung einer eindimensionalen Nanostruktur. Dazu wird eine Beschichtung einer photokatalytischen Verbindung auf einem Substrat aufgetragen und durch eine Maske belichtet. Dadurch bilden sich in den belichteten Bereichen angeregte Zustände. Auf diesem latenten Bild werden dann Metalle elektrolytisch abgeschieden. Nachteilig an dieser Methode ist die kurze Lebensdauer des latenten Bilds, was eine sofortige Weiterbehandlung erfordert. Außerdem ist auch bei dieser Methode ein weiterer Abscheidungsschritt erforderlich, um leitfähige Strukturen zu erhalten.

In der Schrift US 2006/0144713 A1 wird auf die photokatalytische Verbindung ein Polymer aufgetragen, um die Lebensdauer der angeregten Zustände zu verlängern. Dies macht dieses Verfahren noch komplizierter. In den Publikationen Noh, C.-, et al., Advances in Resist Technology and Processing XXII, Proceedings of SPIE, 2005, 5753, 879-886, "A novel patterning method of low-resistivity metals" und Noh, C.-, et al., Chemistry Letters, 2005, 34(1), 82-83, "A novel patterning method of low-resistivity metals" wird beschrieben, dass auch die Verwendung einer Schicht aus amorphen Titandioxid als photokatalytische Schicht möglich ist. Allerdings konnte bei der Verwendung kristalliner Titandioxidnanopartikeln keine ausreichende Auflösung der Strukturen erreicht werden, wahrscheinlich aufgrund der Größe der Partikel, welche zu einer rauen Oberfläche führt. Aufgrund der geringeren photokatalytischen Aktivität von amorphem Titandioxid kann nur eine geringe Menge an Metall photokatalytisch abgeschieden werden.

In der Schrift US 2009/0269510 A1 wird die Herstellung von metallischen Filmen auf einer Beschichtung aus Titandioxidnanopartikeln beschrieben. Dazu werden sphärische Partikel mit einem Durchmesser zwischen 3 nm und 20 nm verwendet. Mit diesem Verfahren kann eine gewisse Strukturierung erreicht werden. Allerdings sind die Strukturen nicht transparent und weisen nur eine geringe Auflösung auf.

Die Publikation Jia, Huimin at al., Materials Research Bulletin, 2009, 44, 1312-1316, "Nonaqueous sol-gel synthesis and growth mechanism of single crystalline TiO2 nanorods with high photocatalytic activity" zeigt die Herstellung von Nanostäben aus Titandioxid.

Es wäre von Vorteil, wenn es auch durch die photokatalytische Abscheidung die Herstellung von transparenten leitfähigen Strukturen möglich ist, was bisher meistens über ITO-Beschichtungen gelöst wird.

### Aufgabe

Aufgabe der Erfindung ist es, ein Verfahren anzugeben, das die Herstellung von metallischen Strukturen auf einfache Weise ermöglicht, insbesondere von leitfähigen Strukturen. Das Verfahren soll auch die Herstellung von transparenten Strukturen ermöglichen.

Diese Aufgabe wird durch die Erfindungen mit den Merkmalen der unabhängigen Ansprüche gelöst. Vorteilhafte Weiterbildungen der Erfindungen sind in den Unteransprüchen gekennzeichnet. Der Wortlaut sämtlicher Ansprüche wird hiermit durch Bezugnahme zum Inhalt dieser Beschreibung gemacht.

Die Aufgabe wird durch ein Verfahren zur Herstellung von metallischen Strukturen gelöst, wobei eine Initiatorzusammensetzung auf ein Substrat aufgetragen wird, wobei die Zusammensetzung als Initiator photokatalytisch aktive Nanostäbe umfasst. In einem weiteren Schritt wird auf das Substrat eine Vorläuferzusammensetzung umfassend mindestens eine Vorläuferverbindung für eine Metallschicht aufgetragen. In einem weiteren Schritt wird die Vorläuferverbindung unter Einwirkung von elektromagnetischer Strahlung auf den Initiator zum Metall reduziert.

Dabei bildet sich üblicherweise eine Metallschicht. Hierbei wird unter einer metallischen Schicht im Sinne der Erfindung eine Schicht aus einem Metall verstanden. Solche Schichten können bei ausreichender Dicke auch leitfähig sein. Solche leitfähigen Schichten sind besonders bevorzugt. Dabei wird unter leitfähig nicht unbedingt die Herstellung von Strukturen verstanden, welche für sich eine Leiterbahn darstellen. Auch die Herstellung von Punkten aus leitfähigem Material stellt eine im Prinzip leitfähige Struktur dar.

Im Folgenden werden einzelne Verfahrensschritte näher beschrieben. Die Schritte müssen nicht notwendigerweise in der angegebenen Reihenfolge durchgeführt werden, und das zu schildernde Verfahren kann auch weitere, nicht genannte Schritte aufweisen.

Das beschriebene Verfahren hat den Vorteil, dass die verwendeten Nanostäbe eine bessere photochemische Reaktivität aufweisen, als entsprechende Nanopartikel oder amorphes Titandioxid. Dadurch kann die Vorläuferverbindung nicht nur direkt um Metall reduziert werden, sondern auch in ausreichender Menge, um leitfähige Strukturen zu gewährleisten. Da die Vorläuferverbindung selbst nicht, bzw. nur in geringem Maß, lichtempfindlich ist, kann sie deutlich einfacher gehandhabt werden.

Das Substrat, das mit dem photokatalytischen Initiator beschichtet werden soll, kann jedes für diesen Zweck geeignete Material sein. Beispiele für geeignete Materialien sind Metalle oder Metalllegierungen, Glas, Keramik, einschließlich Oxidkeramik, Glaskeramik oder Kunststoffe, sowie Papier und andere zellulosehaltige Materialien. Selbstverständlich sind auch Substrate verwendbar, die eine Oberflächenschicht aus den vorstehend genannten Materialien aufweisen. Bei der Oberflächenschicht kann es sich z.B. um eine Metallisierung, eine Emaillierung, eine Glas- oder Keramikschicht oder eine Lackierung handeln.

Beispiele für Metalle oder Metalllegierungen sind Stahl, einschließlich Edelstahl, Chrom, Kupfer, Titan, Zinn, Zink, Messing und Aluminium. Beispiele für Glas sind Natronkalkglas, Borosilikatglas, Bleikristall und Kieselglas. Es kann sich z.B. um Flachglas, Hohlglas wie Behälterglas, oder um Laborgeräteglas handeln. Bei der Keramik handelt es sich z.B. um eine Keramik auf Basis der Oxide SiO₂, Al₂O₃, ZrO₂ oder MgO oder der entsprechenden Mischoxide. Beispiele für den Kunststoff, der, wie auch das Metall, als Folie vorliegen kann, sind Polyethylen, z.B. HDPE oder LDPE, Polypropylen, Polyisobutylen, Polystyrol (PS), Polyvinylchlorid (PVC), Polyvinylidenchlorid, Polyvinylbutyral, Polytetrafluorethylen, Polychlortrifluorethylen, Polyacrylate, Polymethacrylate wie Polymethylmethacrylat (PMMA), Polyamid, Polyethylenterephthalat (PET), Polycarbonat, regenerierte Cellulose, Cellulosenitrat, Celluloseacetat, Cellulosetriacetat (TAC), Celluloseacetatbutyrat oder Kautschuk-Hydrochlorid. Eine lackierte Oberfläche kann aus üblichen Grundanstrichen oder Lacken gebildet sein. In einer bevorzugten Ausführungsform sind die Substrate Folien, insbesondere Polyethylenterephthalatfolien oder Polyimidfolien.

Der Initiator umfasst photokatalytisch aktive Nanostäbe. Dabei wird unter einem photokatalytisch aktiven Material eine Verbindung verstanden, welche die Reduktion eines Metallions in einem Metallkomplex zum Metall direkt und/oder durch oxidative Aktivierung des Metallkomplexes oder einer weiteren Substanz indirekt bewirkt, ohne dabei selbst zersetzt zu werden. Durch die bei der Oxidation entstehenden Produkte kommt es zu einer Zersetzung des Metallkomplexes und Reduktion des Metallions des Komplexes. Bei dem photokatalytischen Material kann es sich um ZnO oder TiO₂ handeln, wobei TiO₂ bevorzugt ist. Besonders bevorzugt liegt das TiO₂ als Anatas vor.

Die Initiatorzusammensetzung umfasst Nanostäbe. Im Sinne der Erfindung werden darunter im Allgemeinen längliche Körper verstanden, im Gegensatz zu sphärischen Nanopartikeln. Ein solcher stabförmiger Körper lässt sich beispielsweise anhand von zwei Parametern beschreiben. Zum einen der Durchmesser des Stabs und zum anderen die Länge des Stabs. Die Nanostäbe zeichnen sich dadurch aus, dass sie einen Durchmesser von unter 100 nm, bevorzugt unter 50 nm, bevorzugt unter 40 nm, besonders bevorzugt unter 30 nm aufweisen. Ihre Länge liegt dabei unter 500 nm, bevorzugt unter 400 nm, besonders bevorzugt unter 200 nm. Die Dimensionen können mittels TEM ermittelt werden. Die Nanostäbe liegen in TEM meistens auf der längeren Seite. Die bestimmten Durchmesser stellen daher einen Durchschnitt der Durchmesser von Nanostäben unterschiedlicher Orientierung dar. In der Zusammensetzung können auch Agglomerate von Nanostäben auftreten. Die Angaben beziehen sich immer auf ein Nanostäbchen.

In einer bevorzugten Ausführungsform weisen die Nanostäbe ein Verhältnis von Länge zu Durchmesser ein Verhältnis zwischen 1000:1 und 1,5:1 auf, bevorzugt zwischen 500:1 und 2:1, besonders bevorzugt zwischen 100:1 und 5:1.

In einer bevorzugten Ausführungsform weisen die Nanostäbe eine Länge zwischen 30 und 100 nm auf, bei einem Verhältnis von Länge zu Durchmesser von zwischen 10:1 und 3:1.

Durch ihre längliche Ausdehnung besitzen die Nanostäbe eine besonders hohe photokatalytische Aktivität.

Zur Herstellung der Nanostäbe kommen alle dem Fachmann bekannten Verfahren in Betracht. Dies sind beispielsweise hydrolytische oder nicht hydrolytische Sol-Gel-Verfahren. Für solche Verfahren sind Bedingungen bekannt unter denen Nanostäbe erhalten werden.

Die Nanostäbe werden bevorzugt durch einen nicht hydrolytischen Sol-Gel-Prozess hergestellt. Dazu wird eine hydrolysierbare Titanverbindung und/oder Zinkverbindung mit einem Alkohol oder einer Karbonsäure umgesetzt, bevorzugt unter Schutzgasathmosphäre. Die Reaktion wird bevorzugt bei Temperaturen zwischen 10 °C und 100 °C, bevorzugt zwischen 15 °C und 30 °C durchgeführt. In einer Ausführungsform kann die Umsetzung bei Raumtemperatur durchgeführt werden.

Bei der hydrolysierbaren Titanverbindung handelt es sich insbesondere um eine Verbindung der Formel TiX₄, wobei die hydrolysierbaren Gruppen X, die verschieden voneinander oder vorzugsweise gleich sind, beispielsweise Wasserstoff, Halogen (F, Cl, Br oder I, insbesondere Cl und Br), Alkoxy (vorzugsweise C₁₋₆-Alkoxy, insbesondere C₁₋₄-Alkoxy, wie z.B. Methoxy, Ethoxy, n-Propoxy, i-Propoxy, Butoxy, i-Butoxy, sek.-Butoxy und tert.-Butoxy), Aryloxy (vorzugsweise C₆₋₁₀-Aryloxy, wie z.B. Phenoxy), Acyloxy (vorzugsweise C₁₋₆-Acyloxy, wie z.B. Acetoxy oder Propionyloxy) oder Alkylcarbonyl (vorzugsweise C₂₋₇-Alkylcarbonyl, wie z.B. Acetyl) sind. Ein Beispiel für ein Halogenid ist TiCl₄. Weitere hydrolysierbare Reste X sind Alkoxygruppen, insbesondere C₁₋₄-Alkoxy. Konkrete Titanate sind Ti (OCH₃)₄, Ti(OC₂H₅)₄ und Ti (n- oder i-OC₃H₇)₄. Bevorzugt ist TiCl₄.

Im Falle einer Zinkverbindung kommen Karbonsäureverbindung des Zinks in Betracht, beispielsweise Zn(OAc)₂.

Bei dem Alkohol oder der Karbonsäure handelt es sich in der Regel um niedere Alkohole oder Karbonsäuren. Beispiele für solche Verbindung sind Alkylalkohole, wie Methanol, Ethanol, n-Propanol, i-Propanol, n-Butanol, i-Butanol, Neopentanol, Glykol, 1,3-Propandiol oder Benzylalkohole, wie Benzylalkohol, welche auch am Aromaten substituiert sein können. Beispiele für Karbonsäuren umfassen beispielsweise Ameisensäure, Essigsäure, Propionsäure, Buttersäure, Oxalsäure. Es können auch Mischungen der Lösungsmittel eingesetzt werden. Bevorzugt ist die Verwendung von Benzylalkohol. Die Verbindung wird bevorzugt auch als Lösungsmittel eingesetzt, d.h. im deutlichen Überschuss.

Um kristalline Nanostäbe zu erhalten, kann es erforderlich sein, noch eine Wärmebehandlung, bevorzugt eine Wärmebehandlung unter autogenem Druck durchzuführen. Dazu wird die Reaktionsmischung in einem geschlossenen Behälter bei einer Temperatur zwischen 50 °C und 300 °C, bevorzugt zwischen 50 °C und 100 °C für 2 Stunden bis 48 Stunden behandelt.

Die erhaltenen Nanostäbe können durch einfache Zentrifugation und Entfernung des Lösungsmittels gewonnen werden.

Die Nanostäbe können auch dotiert sein, beispielsweise um ihre Absorption in andere Spektralbereiche zu verschieben.

Dazu kann bei den Nanostäben bei ihrer Herstellung eine geeignete Metallverbindung zur Dotierung eingesetzt werden, z.B. ein Oxid, ein Salz oder eine Komplexverbindung, z.B. Halogenide, Nitrate, Sulfate, Carboxylate (z.B. Acetate) oder Acetylacetonate. Die Verbindung sollte in dem für die Herstellung der Nanostäbe verwendeten Lösungsmittel zweckmäßigerweise löslich sein. Als Metall eignet sich jedes Metall, insbesondere ein Metall ausgewählt aus der 5. bis 14. Gruppe des Periodensystems der Elemente und der Lanthanoiden und Actiniden. Die Gruppen werden hier entsprechend dem neuen IUPAC-System aufgeführt, wie es in Römpp Chemie Lexikon, 9. Auflage, wiedergegeben ist. Das Metall kann in der Verbindung in jeder geeigneten Oxidationsvorstufe vorkommen.

Beispiele für geeignete Metalle für die Metallverbindung sind W, Mo, Zn, Cu, Ag, Au, Sn, In, Fe, Co, Ni, Mn, Ru, V, Nb, Ir, Rh, Os, Pd und Pt. Metallverbindungen von W(VI), Mo(VI), Zn(II), Cu(II), Au(III), Sn(IV), In(III), Fe(III), Co(II), V(V) und Pt(IV) werden bevorzugt verwendet. Sehr gute Ergebnisse werden insbesondere mit W(VI), Mo(VI), Zn(II), Cu(II), Sn(IV), In(III) und Fe(III) erreicht. Konkrete Beispiele für bevorzugte Metallverbindungen sind WO₃, MoO₃, FeCl₃, Silberacetat, Zinkchlorid, Kupfer(II)-chlorid, Indium(III)-oxid und Zinn(IV)-acetat.

Das Mengenverhältnis zwischen der Metallverbindung und der Titan- oder Zinkverbindung hängt auch von dem eingesetzten Metall und dessen Oxidationsstufe ab. Im Allgemeinen werden z.B. solche Mengenverhältnisse eingesetzt, dass sich ein Molverhältnis von Metall der Metallverbindung zu Titan/Zink der Titan- oder Zinkverbindung (Me/Ti(Zn)) von 0,0005:1 bis 0,2:1, bevorzugt 0,001:1 bis 0,1:1 und bevorzugter 0,005:1 bis 0,1:1 ergibt.

Die erhaltenen Nanostäbe können auch oberflächenmodifiziert werden, beispielsweise um ihnen eine Kompatibilität mit dem verwendeten Matrixmaterial zu verleihen. Außerdem ist es, beispielsweise durch die Oberflächenmodifikation mit fluorierten Gruppen möglich, einen Konzentrationsgradienten der Nanostäbe innerhalb der Initiatorschicht zu erreichen. Die Nanostäbe lagern sich an der nach dem Auftragen freien Oberfläche der Initiatorschicht an und können bei der Bestrahlung das Substrat nicht schädigen.

Bei der Initiatorzusammensetzung handelt es sich in der Regel um eine Dispersion der Nanostäbe in mindestens einem Lösungsmittel. Der Anteil der Nanostäbe beträgt dabei unter 20 Gew.-%, bevorzugt unter 10 Gew.-%, besonders bevorzugt unter 5 Gew.-%. Ein bevorzugter Bereich liegt zwischen 0,5 Gew.-% und 3 Gew.-%. Beispiele sind 1 Gew.-%, 1,5 Gew.-%, 2 Gew.-% und 2,5 Gew.-%. Dabei bezieht sich der Anteil auf die Initiatorzusammensetzung.

Als Lösungsmittel eignen sich dem Fachmann bekannte Lösungsmittel für Nanostäbe. Bevorzugt sind Lösungsmittel, welche einen Siedepunkt von unter 150 °C aufweisen. Beispiele hierfür sind deionisiertes H₂O, Methanol, Ethanol, Isopropanol, n-Propanol oder Butanol. Es können auch Mischungen eingesetzt werden. Beispiele für solche Mischungen sind H₂O : Alkohol zwischen 80:20 Gew.-% und 20:80 Gew.-%, bevorzugt 50:50 Gew.-% bis 20:80 Gew.-%, wobei als Alkohol bevorzugt Ethanol verwendet wird.

Zum Aufbringen der Initiatorzusammensetzung können übliche Verfahren verwendet werden, beispielsweise Tauchen, Rollen, Rakeln, Fluten, Ziehen, Spritzen, Schleudern oder Aufstreichen. Die aufgebrachte Dispersion wird gegebenenfalls getrocknet und wärmebehandelt, etwa zur Härtung oder Verdichtung. Die dafür verwendete Wärmebehandlung hängt natürlich vom Substrat ab. Bei Kunststoffsubstraten oder Kunststoffoberflächen, die in der Regel eine Sperrschicht aufweisen (siehe nachstehend), können naturgemäß keine sehr hohen Temperaturen verwendet werden. So werden Polycarbonat (PC)-Substrate z.B. bei etwa 130 °C für 1 h wärmebehandelt. Allgemein erfolgt die Wärmebehandlung z.B. bei einer Temperatur von 100 bis 200 °C und, sofern kein Kunststoff vorhanden ist, bis zu 500 °C oder mehr. Die Wärmebehandlung erfolgt z.B. 2 min bis 2 h.

Es können Schichten von unterschiedlicher Dicke erhalten werden. So können Schichten mit einer Dicke zwischen 5 nm bis 200 µm erhalten werden. Bevorzugte Schichtdicken liegen zwischen 10 nm und 1 µm, bevorzugt 50 nm bis 700 nm. Die Schichtdicke kann aber auch zwischen 20 µm und 70 µm liegen.

In einem nächsten Schritt wird eine Vorläuferzusammensetzung umfassend mindestens eine Vorläuferverbindung für eine Metallschicht auf das Substrat aufgetragen. Zum Aufbringen der Vorläuferzusammensetzung können übliche Verfahren verwendet werden, beispielsweise Tauchen, Rollen, Rakeln, Fluten, Ziehen, Spritzen, Schleudern oder Aufstreichen. Üblicherweise ist die Vorläuferzusammensetzung eine Lösung oder Suspension der mindestens einen Vorläuferverbindung. Diese Lösung kann auch ein Gemisch aus mehreren Vorläuferverbindungen enthalten. Auch können weitere Hilfsstoffe, wie Reduktionsmittel oder Benetzungshilfsmittel in der Lösung enthalten sein.

Bei der Vorläuferverbindung handelt es sich bevorzugt um einen Metallkomplex. Dieser umfasst mindestens ein Metallion oder ein Metallatom und mindestens eine Art von Liganden. Bei dem Metall handelt es sich beispielsweise um Kupfer, Silber, Gold, Nickel, Zink, Aluminium, Titan, Chrom, Mangan, Wolfram, Platin oder Palladium. In einer bevorzugten Ausführungsform ist die Vorläuferverbindung ein Silber,- Gold- oder Kupferkomplex, besonders bevorzugt ein Silberkomplex. Die Vorläuferverbindung kann auch mehrere Arten von Metall oder Mischungen von Metallkomplexen umfassen.

Als Ligand werden in der Regel Chelatliganden eingesetzt. Diese sind in der Lage besonders stabile Komplexe zu bilden. Dabei handelt es sich um Verbindungen, welche mehrere Hydroxylgruppen und/oder Aminogruppen aufweisen. Bevorzugt sind Verbindungen mit einem Molekulargewicht von unter 200 g/mol, besonders bevorzugt Verbindungen mit mindestens einer Hydroxylgruppe und mindestens einer Aminogruppe. Beispiele für mögliche Verbindungen sind 3-Amino-1,2-propandiol, 2-Amino-1-butanol, Tris(hydroxymethyl)-aminomethan (TRIS), NH₃, Nikotinamid oder 6-Aminohexansäure. Es können auch Mischungen dieser Liganden verwendet werden. Im Falle des bevorzugten Silberkomplexes ist als Ligand TRIS bevorzugt.

Die Vorläuferzusammensetzung ist bevorzugt eine Lösung der Vorläuferverbindung. Als Lösungsmittel kommen alle geeigneten Lösungsmittel in Betracht. Dies sind beispielsweise Wasser, Alkohole, wie Methanol, Ethanol, n-Propanol oder i-Propanol. Es können auch Mischungen der Lösungsmittel verwendet werden, bevorzugt Mischungen von Wasser und Ethanol. Als Mischungsverhältnis ist ein Verhältnis von 50:50 Gew.-% bis zu 20:80 Gew.-% von H₂O:Alkohol, bevorzugt Ethanol, geeignet.

Die Vorläuferzusammensetzung kann zusätzlich noch weitere Hilfsmittel, wie Tenside oder unterstützende Reduktionsmittel enthalten.

Die Vorläuferzusammensetzung kann auf beliebige Weise auf das Substrat aufgetragen werden. Dabei wird die Vorläuferzusammensetzung so aufgetragen, dass durch die photokatalytische Aktivität der Initiatorschicht direkt oder indirekt die Reduktion des Metallions zum Metall ausgelöst werden kann. Üblicherweise geschieht dies dadurch, dass die Vorläuferzusammensetzung direkt auf die Initiatorschicht aufgetragen wird.

Zum Aufbringen der Vorläuferzusammensetzung können übliche Verfahren verwendet werden, beispielsweise Tauchen, Sprühen, Rollen, Rakeln, Fluten, Ziehen, Spritzen, Schleudern oder Aufstreichen.

Beispielsweise kann das Auftragen der Vorläuferzusammensetzung über einen Rahmen, welcher auf das Substrat gelegt wird und in den dann gebildeten durch den Rahmen begrenzten Raum die Vorläuferzusammensetzung gegeben wird. Der Rahmen kann aus einem elastischen Material bestehen. Der Rahmen kann beliebige Formen aufweisen. Üblicherweise ist es ein rechteckiger Rahmen. Der Rahmen umschließt dabei beispielsweise eine Fläche auf dem Substrat von zwischen 1 cm² bis 625 cm² bei einer Seitenlänge zwischen 1 cm und 25 cm. Die Höhe des Rahmens auf dem Substrat bestimmt dabei die Dicke der aufgetragenen Vorläuferzusammensetzung. Der Rahmen kann dabei zwischen 25 µm und 5 mm hoch sein, bevorzugt zwischen 30 µm und 2 mm.

In einem nächsten Schritt wird das Metallion der Vorläuferverbindung durch Einwirkung von elektromagnetischer Strahlung auf den Initiator zum Metall reduziert. Dabei bildet sich eine metallische Schicht. Bei der elektromagnetischen Strahlung handelt es sich um Strahlung der Wellenlänge zur Anregung des Initiators. Dabei kann die Bestrahlung durch Verwendung einer flächigen Strahlungsquelle, wie einer Lampe, oder durch Laser geschehen. Bevorzugt wird eine Wellenlänge im sichtbaren oder ultravioletten (UV) Bereich des elektromagnetischen Spektrums verwendet, bevorzugt Strahlung mit einer Wellenlänge von < 500 nm, beispielsweise zwischen 200 und 450 nm oder zwischen 250 nm bis 410 nm. Bevorzugt ist es Strahlung mit einer Wellenlänge von <400 nm.

Als Lichtquelle kann jede geeignete Lichtquelle verwendet werden. Beispiele für eine Lichtquelle sind Quecksilberdampflampen oder Xenonlampen.

Die Lichtquelle ist in geeignetem Abstand zu dem zu belichtenden Substrat angeordnet. Der Abstand kann dabei beispielsweise zwischen 2,5 cm und 50 cm betragen. Die Intensität der Strahlung kann dabei in einem Spektralbereich von 250 nm bis 410 nm zwischen 30 mW/cm² und 70 mW/cm² liegen.

Die Bestrahlung sollte möglichst senkrecht zur zu belichtenden Oberfläche erfolgen.

Die Bestrahlung wird in der zur Bildung der metallischen Schicht ausreichenden Dauer durchgeführt. Die Dauer hängt dabei von der Beschichtung, der Art des Initiators, der Art der Lampe, des verwendeten Wellenlängenbereichs und der Intensität der Bestrahlung ab. Falls leitfähige Strukturen erzeugt werden sollen, kann eine längere Bestrahlung erforderlich sein. Bevorzugt ist eine Dauer der Bestrahlung zwischen 5 Sekunden und 10 Minuten, bevorzugt zwischen 20 Sekunden und 4 Minuten.

Falls zur Bestrahlung ein Laser verwendet wird, kann beispielsweise ein Argon-Ionen-Laser (351 nm) mit 10 mW eingesetzt werden, dessen Laserstrahl fokussiert und kollimiert und mit einer Geschwindigkeit von 2 mm/s über das zu bestrahlende Substrat geführt wird.

In einer weiteren Ausführungsform der Erfindung wird das Substrat nach der Bestrahlung und Reduktion der Vorläuferverbindung weiter behandelt. So kann beispielsweise die nicht reduzierte überschüssige Vorläuferzusammensetzung durch Spülen der Oberfläche entfernt werden, beispielsweise mit deionisiertem Wasser oder einer anderen geeigneten Substanz. Das beschichtete Substrat kann danach getrocknet werden, beispielsweise durch Erwärmen in einem Ofen, Druckluft und/oder durch Trocknen bei Raumtemperatur.

Es können auch noch weitere Schichten, beispielsweise zum Schutz der beschichteten Oberfläche vor Oxidation und Wasser oder vor UV-Strahlung aufgebracht werden.
Beim Auftragen der Vorläuferzusammensetzung und/oder bei der Reduktion erfolgt eine Strukturierung. Darunter wird im Sinne der Erfindung eine Vorbereitung der räumlich begrenzten Erzeugung der metallischen Struktur verstanden. Dies ist auf unterschiedliche Weise möglich. Zum einen kann das Substrat nur in bestimmten Bereichen mit der Initiatorzusammensetzung beschichtet werden. Außerdem ist es möglich, die Vorläuferzusammensetzung nur auf bestimmte Bereiche aufzubringen. Desweiteren kann natürlich auch die Einwirkung der elektromagnetischen Strahlung auf bestimmte Bereiche begrenzt werden. Diese Verfahren können natürlich auch in Kombination verwendet werden. So ist es beispielsweise möglich, die Vorläuferzusammensetzung flächig aufzubringen und dann durch eine Maske zu belichten. Es ist natürlich ebenso möglich, die Vorläuferzusammensetzung gezielt aufzubringen und danach flächig zu belichten.

Für die Qualität der erhaltenen Strukturen spielt neben der photokatalytischen Aktivität des Initiators auch die Qualität, beispielsweise die Benetzungsfähigkeit oder Rauheit, der Initiatorschicht in Bezug auf die Vorläuferzusammensetzung eine Rolle. Gerade die erfindungsgemäßen Initiatorzusammensetzungen zeichnen sich dadurch aus, dass auf ihnen ein gezieltes Auftragen der Vorläuferzusammensetzung und/oder eine sehr gezielte Reduktion der Vorläuferverbindung möglich sind.

In einer bevorzugten Ausführungsform der Erfindung, umfasst die Strukturierung Strukturen mit einer minimalen lateralen Ausdehnung von unter 500 µm. Dies bedeutet, dass die hergestellten Strukturen auf dem Substrat eine minimale Breite von 500 µm aufweisen, bevorzugt ist eine Ausdehnung von unter 100 µm, 50 µm, 20 µm, besonders bevorzugt 10 µm.

Für die erzielte Auflösung der metallischen Strukturen, d.h. der Ausbildung der Metallschicht, ist die Struktur der gebildeten photokatalytischen Schicht von Bedeutung. Neben der Verwendung der Nanostäbe ist es möglich, die erzielte Auflösung durch eine Vorbehandlung des Substrats zu erreichen. Eine solche Vorbehandlung kann auch das Aufbringen einer weiteren Schicht bedeuten.

In einer bevorzugten Weiterbildung der Erfindung umfasst die Vorbehandlung eine Plasmabehandlung, Koronabehandlung, Flammenbehandlung und/oder das Auftragen und Härten einer organisch-anorganischen Beschichtung. Eine Plasmabehandlung, Koronabehandlung und/oder Flammenbehandlung kommt insbesondere bei Foliensubstraten, insbesondere bei Kunststofffolien in Betracht. Dabei wurde gefunden, dass eine solche Behandlung die Qualität der erhaltenen photokatalytischen Schicht verbessert.

Mögliche Wege zum Erhalt von Plasma unter Vakuumbedingungen sind in der Literatur häufig beschrieben worden. Die elektrische Energie kann durch induktive oder kapazitive Mittel verknüpft werden. Sie kann Gleichstrom oder Wechselstrom sein; die Frequenz des Wechselstroms kann von einigen kHz bis in den MHz-Bereich reichen. Eine Energiezufuhr im Mikrowellenbereich (GHz) ist auch möglich.

Als primäre Plasmagase können beispielsweise He, Argon, Xenon, N₂, O₂, H₂, Dampf oder Luft, und ebenso Gemische aus diesen Verbindungen verwendet werden. Bevorzugt ist ein Sauerstoffplasma.

Üblicherweise werden die Substrate vorher gesäubert. Dies kann durch einfaches Abspülen mit einem Lösungsmittel geschehen. Die Substrate werden danach gegebenenfalls getrocknet und dann für unter 5 Minuten mit Plasma behandelt. Die Behandlungsdauer kann von der Empfindlichkeit des Substrats abhängen. Üblicherweise beträgt sie zwischen 1 und 4 Minuten.

Eine weitere Möglichkeit die Qualität der photokatalytischen Schicht zu verbessern, ist die vorherige Flammenbehandlung der Oberfläche. Eine solche Behandlung ist dem Fachmann bekannt. Die auszuwählenden Parameter werden durch das bestimmte zu behandelnde Substrat vorgegeben. Beispielsweise werden die Flammentemperaturen, die Flammenintensität, die Verweilzeiten, der Abstand zwischen Substrat und Ofen, das Wesen des Verbrennungsgases, Luftdruck, Feuchtigkeit, auf das in Frage stehende Substrat abgestimmt. Als Flammengase können beispielsweise Methan, Propan, Butan oder ein Gemisch aus 70 % Butan und 30 % Propan verwendet werden. Auch diese Behandlung findet bevorzugt bei Folien, besonders bevorzugt bei Kunststofffolien Anwendung.

In einer weiteren Ausführungsform der Erfindung enthält die Initiatorzusammensetzung eine Verbindung mit mindestens 2 polaren Gruppen. Bevorzugt sind dies organische Verbindungen. Unter polaren Gruppen werden Gruppen verstanden, welche O, N, oder S enthalten. Bevorzugt sind es Verbindungen, welche mindestens 2 OH, NH₂, NH oder SH-Gruppen enthalten. Solche Verbindungen können zu einer Verbesserung der erhaltenen Initiatorschicht führen. Beispiele für solche Verbindungen sind Oligomere von Verbindungen, wie 1,2-Ethandiol, 1,3-Propandiol, 1,4-Butandiol, 1,2-Ethylendiamin, 1,3-Propandiamin, 1,4-Butandiamin, welche jeweils über ein Sauerstoff, Stickstoff oder Schwefelatom verknüpft sind. Dabei bestehen Oligomere aus 2 bis 4 der vorstehend genannten Verbindungen. Beispiele sind Monoethylenglycol (MEG), Diethylenglykol (DEG), Triethylenglykol.

Die Verbindung wird bevorzugt in Anteilen von unter 10 Gew.-% bezogen auf die Masse der Suspension an Nanostäben, bevorzugt unter 5 Gew.-%, besonders bevorzugt zwischen 1 bis 4 Gew.-% eingesetzt.

In einer bevorzugten Ausführungsform umfasst die Initiatorzusammensetzung ein anorganisches oder organisch modifiziertes anorganisches matrixbildendes Material. Hierbei kann es sich insbesondere um anorganische Sole oder organisch modifizierte anorganische Hybridmaterialien oder Nanokomposite handeln. Beispiele hierfür sind gegebenenfalls organisch modifizierte Oxide, Hydrolysate und (Poly)Kondensate von mindestens einem glas- oder keramikbildenden Element M, insbesondere einem Element M aus den Gruppen 3 bis 5 und/oder 12 bis 15 des Periodensystems der Elemente, bevorzugt von Si, Al, B, Ge, Pb, Sn, Ti, Zr, V und Zn, insbesondere solche von Si und Al, am meisten bevorzugt Si, oder Mischungen davon. Es können auch anteilig Elemente der Gruppen 1 und 2 des Periodensystems (z.B. Na, K, Ca und Mg) und der Gruppen 5 bis 10 des Periodensystems (z.B. Mn, Cr, Fe und Ni) oder Lanthanoiden im Oxid, Hydrolysat oder (Poly)Kondensat vorhanden sein. Ein bevorzugtes organisch modifiziertes anorganisches Hybridmaterial sind Polyorganosiloxane. Besonders bevorzugt werden hierfür Hydrolysate von glas- oder keramikbildenden Elementen, insbesondere von Silizium verwendet.

Das anorganische oder organisch-modifizierte anorganische matrixbildende Material wird bevorzugt in einer solchen Menge zugegeben, dass das Verhältnis zwischen den Nanostäben und das matrixbildende Material bezogen in Gew.-% der gesamten Zusammensetzung zwischen 300:1 bis 1:300 beträgt, bevorzugt zwischen etwa 30:1 bis 1:30, besonders bevorzugt zwischen 1:20 und 1:2. Durch diese Zugabe wird eine Verbesserung der Haftung erreicht. Sofern ein organisch-modifiziertes anorganisches matrixbildendes Material verwendet wird, können alle oder nur ein Teil der enthaltenen glas- oder keramikbildenden Elemente M eine oder mehrere organische Gruppen als nicht hydrolysierbare Gruppen aufweisen.

Die anorganischen oder organisch modifizierten anorganischen matrixbildenden Materialien können nach bekannten Verfahren hergestellt werden, z.B. durch Flammpyrolyse, Plasmaverfahren, Gasphasenkondensationsverfahren, Kolloidtechniken, Präzipitationsverfahren, Sol-Gel-Verfahren, kontrollierte Nukleations- und Wachstumsprozesse, MOCVD-Verfahren und (Mikro)emulsionsverfahren.

Vorzugsweise werden die anorganischen Sole und insbesondere die organisch-modifizierten Hybridmaterialien nach dem Sol-Gel-Verfahren erhalten. Beim Sol-Gel-Verfahren, das auch zur gesonderten Herstellung der Teilchen verwendet werden kann, werden gewöhnlich hydrolysierbare Verbindungen mit Wasser, gegebenenfalls unter saurer oder basischer Katalyse, hydrolysiert und gegebenenfalls zumindest teilweise kondensiert. Die Hydrolyse- und/oder Kondensationsreaktionen führen zur Bildung von Verbindungen oder Kondensaten mit Hydroxy-, Oxogruppen und/oder Oxobrücken, die als Vorstufen dienen. Es können stöchiometrische Wassermengen, aber auch geringere oder größere Mengen verwendet werden. Das sich bildende Sol kann durch geeignete Parameter, z.B. Kondensationsgrad, Lösungsmittel oder pH-Wert, auf die für die Beschichtungszusammensetzung gewünschte Viskosität eingestellt werden. Weitere Einzelheiten des Sol-Gel-Verfahrens sind z.B. bei C.J. Brinker, G.W. Scherer: "Sol-Gel Science - The Physics and Chemistry of Sol-Gel-Processing", Academic Press, Boston, San Diego, New York, Sydney (1990) beschrieben.

Nach dem bevorzugten Sol-Gel-Verfahren werden die Oxide, Hydrolysate oder (Poly)Kondensate durch Hydrolyse und/oder Kondensation aus hydrolysierbaren Verbindungen der oben genannten glas- oder keramikbildenden Elemente erhalten, die gegebenenfalls zur Herstellung des organisch-modifizierten anorganischen Hybridmaterials zusätzlich nicht hydrolysierbare organische Substituenten tragen.

Anorganische Sole werden dabei nach dem Sol-Gel-Verfahren insbesondere aus hydrolysierbaren Verbindungen der allgemeine Formeln MXₙ gebildet, worin M das vorstehend definierte glas- oder keramikbildende Element ist, X wie in nachstehender Formel (I) definiert ist, wobei zwei Gruppen X durch eine Oxogruppe ersetzt sein können, und n der Wertigkeit des Elements entspricht und meist 3 oder 4 ist. Bevorzugt handelt es sich um hydrolysierbare Si-Verbindungen, insbesondere der nachstehenden Formel (I) .

Beispiele für einsetzbare hydrolysierbare Verbindungen von Elementen M, die von Si verschieden sind, sind Al(OCH₃)₃, Al(OC₂H₅)₃, Al(O-n-C₃H₇)₃, Al(O-i-C₃H₇)₃, Al(O-n-C₄H₉)₃, Al(O-sek.-C₄H₉)₃, AlCl₃, AlCl(OH)₂, Al(OC₂H₄OC₄H₉)₃, TiCl₄, Ti(OC₂H₅)₄, Ti(O-n-C₃H₇)₄, Ti(O-i-C₃H₇)₄, Ti(OC₄H₉)₄, Ti(2-ethylhexoxy)₄, ZrCl₄, Zr(OC₂H₅)₄, Zr(O-n-C₃H₇)₄, Zr(O-i-C₃H₇)₄, Zr(OC₄H₉)₄, ZrOCl₂, Zr(2-ethylhexoxy)₄, sowie Zr-Verbindungen, die komplexierende Reste aufweisen, wie z.B. β-Diketon- und (Meth)acrylreste, Natriummethylat, Kaliumacetat, Borsäure, BCl₃, B(OCH₃)₃, B(OC₂H₅)₃, SnCl₄, Sn(OCH₃)₄, Sn(OC₂H₅)₄, VOCl₃ und VO(OCH₃)₃.

Die nachstehenden Ausführungen zum bevorzugten Silizium gelten auch sinngemäß für die anderen Elemente M. Besonders bevorzugt wird das Sol oder das organisch-modifizierte anorganische Hybridmaterial aus einem oder mehreren hydrolysierbaren und kondensierbaren Silanen erhalten, wobei gegebenenfalls mindestens ein Silan einen nicht hydrolysierbaren organischen Rest aufweist. Besonders bevorzugt werden ein oder mehrere Silane mit den folgenden allgemeinen Formeln (I) und/oder (II) verwendet:

SiX₄ (I)

worin die Reste X gleich oder verschieden sind und hydrolysierbare Gruppen oder Hydroxygruppen bedeuten,

RₐSiX₍₄₋ₐ₎ (II)

worin R gleich oder verschieden ist und einen nicht hydrolysierbaren Rest darstellt, der gegebenenfalls eine funktionelle Gruppe aufweist, X die vorstehende Bedeutung hat und a den Wert 1, 2 oder 3, vorzugsweise 1 oder 2, hat.

In den obigen Formeln sind die hydrolysierbaren Gruppen X beispielsweise Wasserstoff oder Halogen (F, Cl, Br oder I), Alkoxy (vorzugsweise C₁₋₆-Alkoxy, wie z.B. Methoxy, Ethoxy, n-Propoxy, i-Propoxy und Butoxy), Aryloxy (vorzugsweise C₆₋₁₀-Aryloxy, wie z.B. Phenoxy), Acyloxy (vorzugsweise C₁₋₆-Acyloxy, wie z.B. Acetoxy oder Propionyloxy), Alkylcarbonyl (vorzugsweise C₂₋₇-Alkylcarbonyl, wie z.B. Acetyl), Amino, Monoalkylamino oder Dialkylamino mit vorzugsweise 1 bis 12, insbesondere 1 bis 6 Kohlenstoffatomen in der bzw. den Alkylgruppe(n).

Der nicht hydrolysierbare Rest R ist beispielsweise Alkyl (vorzugsweise C₁₋₆-Alkyl, wie z.B. Methyl, Ethyl, n-Propyl, Isopropyl, n-Butyl, s-Butyl und t-Butyl, Pentyl, Hexyl oder Cyclohexyl), Alkenyl (vorzugsweise C₂₋₆-Alkenyl, wie z.B. Vinyl, 1-Propenyl, 2-Propenyl und Butenyl), Alkinyl (vorzugsweise C₂₋₆-Alkinyl, wie z.B. Acetylenyl und Propargyl) und Aryl (vorzugsweise C₆₋₁₀-Aryl, wie z.B. Phenyl und Naphthyl) .

Die genannten Reste R und X können gegebenenfalls einen oder mehrere übliche Substituenten, wie z.B. Halogen, Ether-, Phosphorsäure-, Sulfonsäure-, Cyano-, Amid-Mercapto-, Thioether- oder Alkoxygruppen, als funktionelle Gruppen aufweisen.

Der Rest R kann eine funktionelle Gruppe enthalten, über die eine Vernetzung möglich ist. Konkrete Beispiele für die funktionellen Gruppen des Restes R sind Epoxy-, Hydroxy-, Amino-, Monoalkylamino-, Dialkylamino-, Carboxy-, Allyl-, Vinyl-, Acryl-, Acryloxy-, Methacryl-, Methacryloxy-, Cyano-, Aldehyd- und Alkylcarbonylgruppen. Diese Gruppen sind vorzugsweise über Alkylen-, Alkenylen- oder Arylen-Brückengruppen, die durch Sauerstoff- oder Schwefelatome oder -NH-Gruppen unterbrochen sein können, an das Siliziumatom gebunden. Die genannten Brückengruppen leiten sich zum Beispiel von den oben genannten Alkyl-, Alkenyl- oder Arylresten ab. Die Brückengruppen der Reste R enthalten vorzugsweise 1 bis 18, insbesondere 1 bis 8 Kohlenstoffatome.

Besonders bevorzugte hydrolysierbare Silane der allgemeinen Formel (I) sind Tetraalkoxysilane, wie Tetramethoxysilan und insbesondere Tetraethoxysilan (TEOS). Durch saure Katalyse erhaltene anorganische Sole, z.B. TEOS-Hydrolysate, sind besonders bevorzugt. Besonders bevorzugte Organosilane der allgemeinen Formel (II) sind Epoxysilane wie 3-Glycidyloxypropyltrimethoxysilan (GPTS), Methacryloxypropyltrimethoxysilan und Acryloxypropyltrimethoxysilan, wobei GPTS-Hydrolysate mit Vorteil eingesetzt werden können.

Sofern ein organisch-modifiziertes anorganisches Hybridmaterial hergestellt wird, können ausschließlich Silane der Formel (II) oder eine Mischung von Silanen der Formel (I) und (II) eingesetzt werden. Bei den anorganischen Solen auf Siliziumbasis werden ausschließlich Silane der Formel (I) verwendet, wobei gegebenenfalls anteilig hydrolysierbare Verbindungen der obigen Formel MXₙ zugegeben werden.

Besonders bevorzugt sind organisch-modifizierte anorganische Hybridmaterialien, welche aus Solen auf Titanbasis hergestellt werden. Es können auch noch Silane der Formel (I) und/oder (II) zugesetzt werden.

Sofern das anorganische Sol aus im Lösungsmittel dispergierten diskreten Oxidteilchen besteht, können sie die Härte der Schicht verbessern. Bei diesen Teilchen handelt es sich insbesondere um nanoskalige anorganische Teilchen. Die Teilchengröße (röntgenographisch ermitteltes Volumenmittel) liegt z.B. im Bereich von unter 200 nm, insbesondere unter 100 nm, bevorzugt unter 50 nm, z.B. 1 nm bis 20 nm.

Erfindungsgemäß können z.B. anorganische Sole von SiO₂, ZrO₂, GeO₂, CeO₂, ZnO, Ta₂O₅, SnO₂ und Al₂O₃ (in allen Modifikationen, insbesondere als Böhmit AlO(OH)), vorzugsweise Sole von SiO₂, Al₂O₃, ZrO₂, GeO₂ sowie Mischungen derselben als nanoskalige Teilchen verwendet werden. Solche Sole sind zum Teil auch im Handel erhältlich, z.B. Kieselsole, wie die Levasile ® der Bayer AG.

Als anorganisches oder organisch modifiziertes anorganisches matrixbildendes Material kann auch eine Kombination von derartigen nanoskaligen Teilchen mit als Hydrolysaten oder (Poly)Kondensaten vorliegenden anorganischen Solen oder organisch-modifizierten Hybridmaterialien verwendet werden, was hier mit Nanokompositen bezeichnet wird.

Gegebenenfalls können auch organische Monomere, Oligomere oder Polymere aller Art als organische matrixbildende Materialien enthalten sein, die als Flexibilisatoren dienen, wobei es sich um übliche organische Bindemittel handeln kann. Diese können zur Verbesserung der Beschichtungsfähigkeit verwendet werden. In der Regel werden sie nach Fertigstellung der Schicht photokatalytisch abgebaut. Die Oligomere und Polymere können funktionelle Gruppen aufweisen, über die eine Vernetzung möglich ist. Diese Vernetzungsmöglichkeit ist auch gegebenenfalls bei den oben erläuterten organisch modifizierten anorganischen matrixbildenden Materialien möglich. Auch Mischungen anorganischer, organisch modifizierter anorganischer und/oder organischer matrixbildender Materialien sind möglich.

Beispiele für verwendbare organische matrixbildende Materialien sind Polymere und/oder Oligomere, die polare Gruppen, wie Hydroxyl-, primäre, sekundäre oder tertiäre Amino-, Carboxyl- oder Carboxylatgruppen, aufweisen. Typische Beispiele sind Polyvinylalkohol, Polyvinylpyrrolidon, Polyacrylamid, Polyvinylpyridin, Polyallylamin, Polyacrylsäure, Polyvinylacetat, Polymethylmethacrylsäure, Stärke, Gummi arabicum, andere polymere Alkohole wie z.B. Polyethylen-Polyvinylalkohol-Copolymere, Polyethylenglycol, Polypropylenglycol und Poly(4-vinylphenol) bzw. davon abgeleitete Monomere oder Oligomere.

Wie bereits vorstehend erwähnt, sind bei Substraten, die aus einem empfindlichen Material bestehen oder eine Oberflächenschicht (z.B. eine Lackierung oder ein Email) aus einem solchen empfindlichen Material aufweisen, ein unmittelbarer Auftrag nicht oder nur schlecht möglich. Es kann eine Sperrschicht zwischen dem Substrat (gegebenenfalls mit Oberflächenbeschichtung) und der photokatalytischen Schicht angeordnet werden. Hierfür kann eine anorganische Schicht aus einem anorganischen matrixbildenden Material eingesetzt werden. Hierfür können die vorstehend beschriebenen anorganischen Sole verwendet werden.

Es ist auch möglich, eine photokatalytische Schicht mit "eingebauter" Sperrschicht herzustellen, indem ein Konzentrationsgradient von photokatalytisch aktiven Nanostäben in der photokatalytischen Schicht ausgebildet wird. Dies kann beispielsweise mit einer Oberflächenmodifikation der Nanostäbe mit fluorierten organischen Gruppen erreicht werden.

Das matrixbildende Material kann auch zusätzlich Titandioxid, beispielsweise als amorphes TiO₂, TiO₂-Nanopartikeln oder TiO₂-Nanostäben enthalten. Diese Bestandteile können mit einem Anteil zwischen 10 Gew.-% und 80 Gew.-% bezogen auf die Zusammensetzung des matrixbildenden Materials bei der Herstellung der Initiatorzusammensetzung vorliegen, bevorzugt zwischen 25 Gew.-% und 65 Gew.-%.

Die vorstehend als matrixbildenden Komponenten genannten Verbindungen können auch als für die Vorbehandlung des Substrats bei dem Auftragen und Härten der organisch-anorganischen Beschichtung verwendet werden. Dabei können sowohl Sole eingesetzt werden, als auch eine Lösung einer hydrolysierbaren Metallverbindung aufgetragen werden.

Bevorzugt wird eine Lösung eines Silans der Formel II aufgetragen. Besonders Bevorzugt sind dabei Silane der Formel II, bei denen R eine funktionelle Gruppe enthält, über die eine Vernetzung möglich ist. Konkrete Beispiele für die funktionellen Gruppen des Restes R sind Epoxy-, Hydroxy-, Amino-, Monoalkylamino-, Dialkylamino-, Carboxy-, Allyl-, Vinyl-, Acryl-, Acryloxy-, Methacryl-, Methacryloxy-, Cyano-, Aldehyd- und Alkylcarbonylgruppen. Diese Gruppen sind vorzugsweise über Alkylen-, Alkenylen- oder Arylen-Brückengruppen, die durch Sauerstoff- oder Schwefelatome oder -NH-Gruppen unterbrochen sein können, an das Siliziumatom gebunden. Die genannten Brückengruppen leiten sich zum Beispiel von den oben genannten Alkyl-, Alkenyl- oder Arylresten ab. Die Brückengruppen der Reste R enthalten vorzugsweise 1 bis 18, insbesondere 1 bis 8 Kohlenstoffatome.

Besonders bevorzugte Organosilane sind Epoxysilane wie 3-Glycidyloxypropyltrimethoxysilan (GPTS), Methacryloxypropyltrimethoxysilan (MPTS) und Acryloxypropyltrimethoxysilan.

Die Schicht wird nach dem Auftragen getrocknet und entsprechend ihrer funktionellen Gruppe vernetzt. Dies kann den Zusatz von Vernetzungsinitiatoren erfordern.

Nach dem Verfahren können auch noch weitere Schichten aufgebracht werden, beispielsweise um die beschichtete Oberfläche des Substrats gegen UV-Strahlung zu schützen.

Ein besonderer Vorteil des erfindungsgemäßen Verfahrens liegt darin, dass die verwendeten Zusammensetzungen auf einfache Weise auf die Substrate aufgetragen werden. Dabei ermöglicht die Initiatorschicht mit den Nanostäben die Herstellung von besonders feinen Strukturen in nur wenigen Schritten. Zum Einsatz kommen zu diesem Zweck alle bekannten Druckverfahren, wie der Tintenstrahldruck, der Tiefdruck, der Siebdruck, der Offsetdruck oder der Hoch- und Flexodruck. Oftmals werden für den Druck der elektrischen Funktionalitäten auch Kombinationsdrucke der vorab erwähnten Druckverfahren eingesetzt. Es kann nötig sein, die verwendeten Druckplatten, -walzen oder Stempel an die Eigenschaften der Zusammensetzungen anzupassen, beispielsweise durch Anpassung ihrer Oberflächenenergie.

Bei den durch Strukturierung aufgetragenen Strukturen gibt es eigentlich keine Beschränkung. So können sowohl verbundene Strukturen, wie Leiterbahnen aufgetragen werden. Außerdem ist es möglich auch punktförmige Strukturen aufzutragen. Aufgrund der guten Auflösung ist es mit dem Verfahren möglich, für das Auge nicht sichtbare leitfähige Punkte auf eine Folie aufzutragen. Dies spielt bei der Herstellung von Oberflächen für Touch-Screens eine große Rolle.

Die Erfindung betrifft außerdem ein beschichtetes Substrat erhalten nach dem erfindungsgemäßen Verfahren. Ein solches Substrat zeichnet sich durch eine Initiatorschicht aus, welche photokatalytisch aktive Nanostäbe umfasst aus. Diese Schicht weist eine Dicke zwischen 50 nm bis 200 µm auf. Bevorzugte Schichtdicken liegen zwischen 100 nm und 1 µm, bevorzugt 50 nm bis 700 nm. Die Schichtdicke kann aber auch zwischen 20 und 70 µm liegen. Die Schicht kann auch ein Matrixmaterial umfassen, wie bereits für das Verfahren beschrieben. Bevorzugt ist ein organisch-modifiziertes anorganisches Matrixmaterial.

Aus dieser Schicht ist, mindestens in einem Bereich der Oberfläche der Initiatorschicht, eine Metallschicht aufgebracht. Diese Schicht ist nur bis zu 200 nm. Bevorzugte Schichtdicken liegen zwischen 20 und 100 nm, bevorzugt 50 nm bis 100 nm. Als Metall kommen dabei insbesondere Kupfer, Silber, Gold, Nickel, Zink, Aluminium, Titan, Chrom, Mangan, Wolfram, Platin oder Palladium, bevorzugt Silber oder Gold.

In einer Weiterbildung der Erfindung weist die Metallschicht auf der Initiatorschicht eine Strukturierung mit Strukturelementen mit einer Ausdehnung von unter 50 µm, bevorzugt unter 10 µm auf. Bei den Strukturelementen kann es sich um metallische und/oder nicht metallische Bereiche handeln.

In einer besonders vorteilhaften Weiterbildung der Erfindung weist das beschichtete Substrat metallische Strukturen auf, welche mindestens teilweise transparent sind. Dies kann beispielsweise durch das Aufbringen von Strukturen mit einer Auflösung von unter 20 µm auf ein transparentes Substrat erreicht werden, bevorzugt unter 10 µm.

Die beschichteten Substrate, welche mit dem erfindungsgemäßen Verfahren erhalten werden, können für viele Anwendungen eingesetzt werden. Zum einen eignet sich das Verfahren zum Aufbringen von reflektierenden Metallschichten auf Oberflächen. Diese können beispielsweise als reflektierende Schichten in holographischen Anwendungen verwendet werden.

Ein besonderer Vorteil der Erfindung liegt in der Herstellung von leitfähigen Strukturen. Diese eignen sich als Leiterbahnen in elektronischen Anwendungen, insbesondere in Touch-Screen-Displays, Solarkollektoren, Displays, als RFID-Antenne oder in Transistoren. Sie eignen sich daher als Ersatz in Produkten, welche bisher auf ITO (Indiumzinnoxid) Basis hergestellt wurden, wie beispielsweise in TCO-Beschichtungen (TCO: transparent conductive oxide).

Die Strukturen können aber auch im Bereich von Transistoren eingesetzt werden.

Weitere Einzelheiten und Merkmale ergeben sich aus der nachfolgenden Beschreibung von bevorzugten Ausführungsbeispielen in Verbindung mit den Unteransprüchen. Hierbei können die jeweiligen Merkmale für sich alleine oder zu mehreren in Kombination miteinander verwirklicht sein. Die Möglichkeiten, die Aufgabe zu lösen, sind nicht auf die Ausführungsbeispiele beschränkt. So umfassen beispielsweise Bereichsangaben stets alle - nicht genannten - Zwischenwerte und alle denkbaren Teilintervalle.
- Fig. 1: TEM-Aufnahme von Nanostäben aus TiO₂;
- Fig. 2: Elektronenbeugungsbild der Nanostäbe;
- Fig. 3: Maske zur Strukturierung;
- Fig. 4: Schematische Darstellung einer Belichtung durch eine Maske (40: UV-Licht; 42: Maske; 44: Vorläuferzusammensetzung; 46: Initiatorschicht; 48: Substrat);
- Fig. 5: Silberbeschichtung unter Verwendung von lyothermal hergestellten TiO₂-Nanopartikel (a) 10x vergrößert Maßstab 100 µm; (b) 50x vergrößert Maßstab 10 µm;
- Fig. 6: Silberbeschichtung unter Verwendung von "TiO₂-Nanoflakes" (a) 10x vergrößert Maßstab 100 µm; (b) 50x vergrößert Maßstab 10 µm;
- Fig. 7: Silberbeschichtung unter Verwendung von Nanostäben aus TiO₂ (a) 10x vergrößert Maßstab 100 µm; (b) 50x vergrößert Maßstab 10 µm; und
- Fig. 8: Mikrograph einer durch die Maske belichteten Struktur.

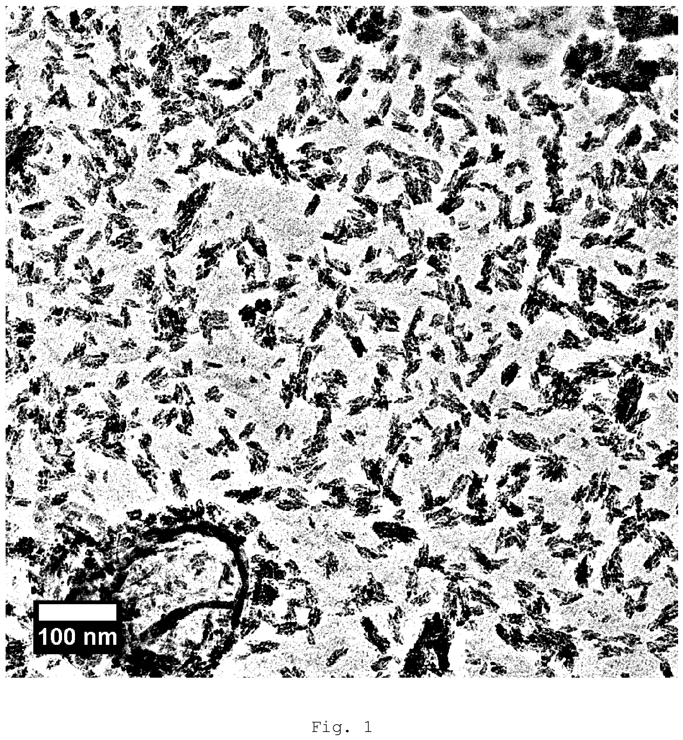

Figur 1 zeigt eine TEM-Aufnahme (Transmissionselektronenmikroskop) von erfindungsgemäßen Nanostäben aus TiO₂. Ihre längliche Ausdehnung ist deutlich zu erkennen.

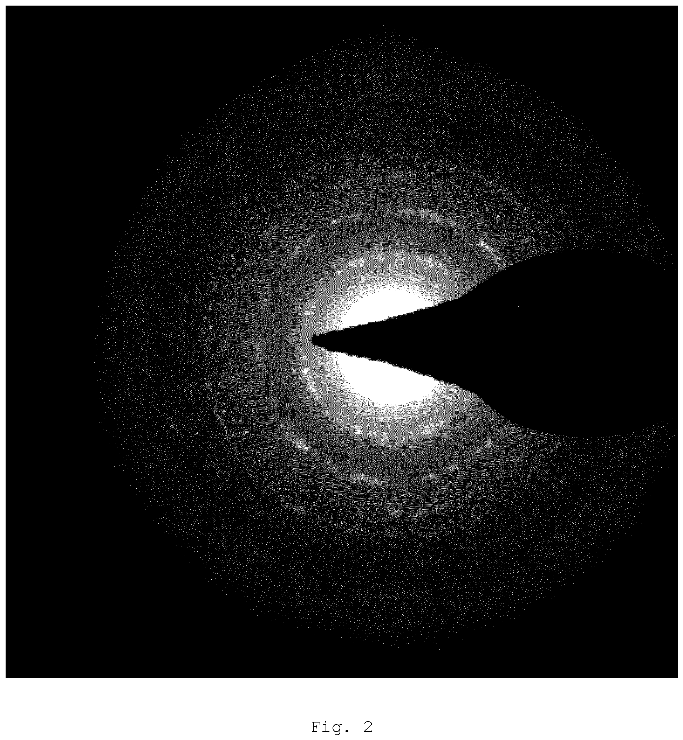

Figur 2 zeigt ein Diffraktogramm von Nanostäben aus TiO₂. Die Reflexe belegen die kristalline Struktur der Nanostäbe.

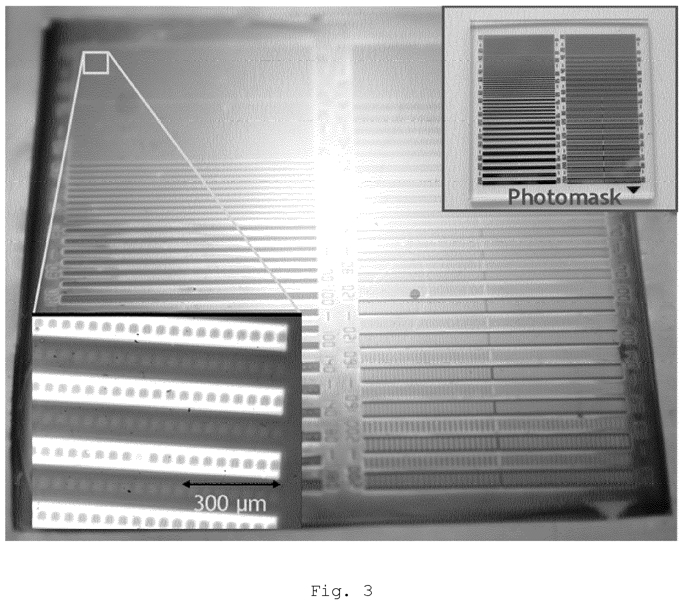

Figur 3 zeigt eine Photomaske aus Quarz zur Durchführung einer Strukturierung beim Belichten. Das Inset unten links zeigt eine Ausschnittsvergrößerung. Die Maske weist Strukturen in einer Größenordnung von >100 µm bis 10 µm auf.

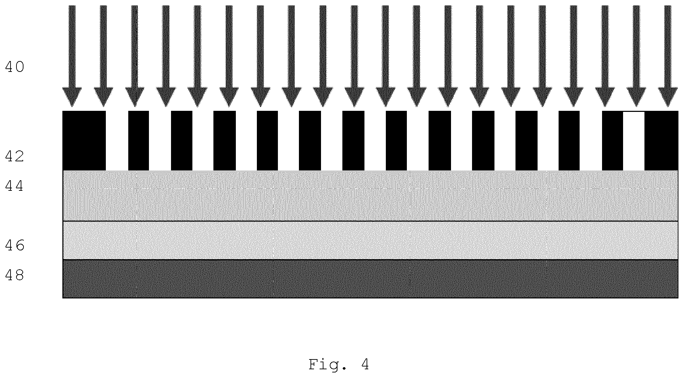

Figur 4 zeigt eine schematische Darstellung einer Belichtung durch eine Maske. Auf dem Substrat (48) befindet sich eine Initiatorschicht (46), welche die photokatalytisch aktiven Nanostäbe enthält. Auf dieser wurde eine Schicht Vorläuferzusammensetzung (44) aufgetragen. Bei dieser Schicht kann es sich um eine auf der Oberfläche der Initiatorschicht befindliche Lösung handeln. Oberhalb dieser Schicht ist eine Maske (42) angeordnet, welche durchlässige und nicht durchlässige Bereiche, welche schwarz dargestellt sind, umfasst. Die Maske führt dazu, dass das eingestrahlte UV-Licht (40) nur durch die durchlässigen Bereich der Maske (42) auf die Vorläuferzusammensetzung (44) gelangen kann und dort die Vorläuferverbindung in der Vorläuferzusammensetzung zum Metall reduzieren kann. In den nicht belichteten Bereichen wird kein Metall abgeschieden.

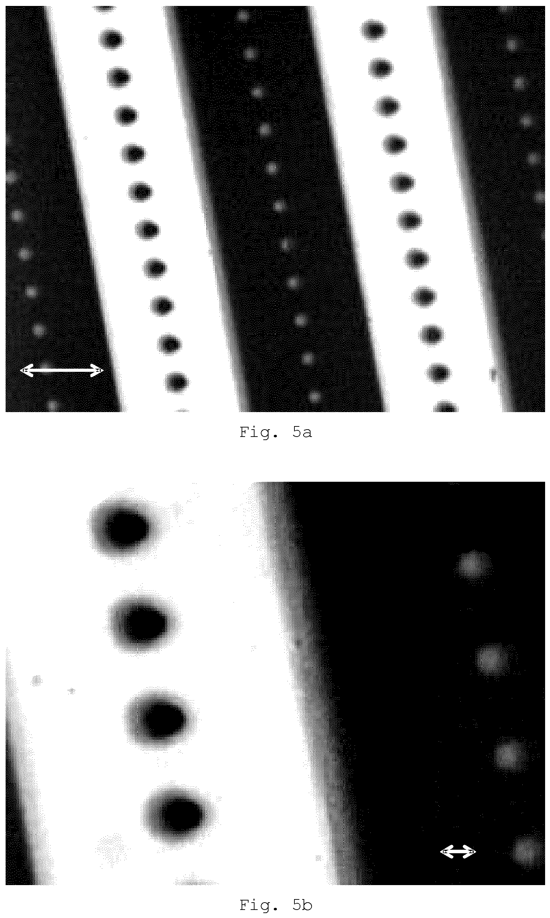

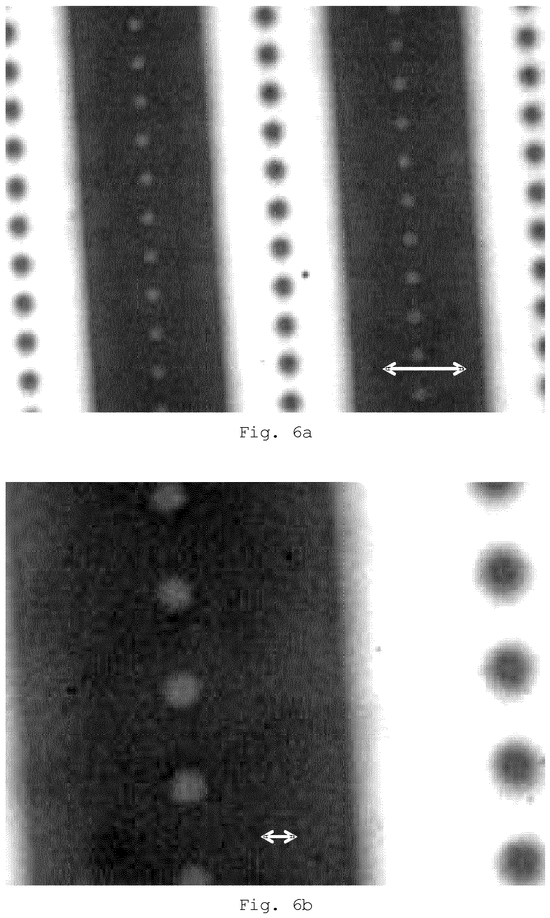

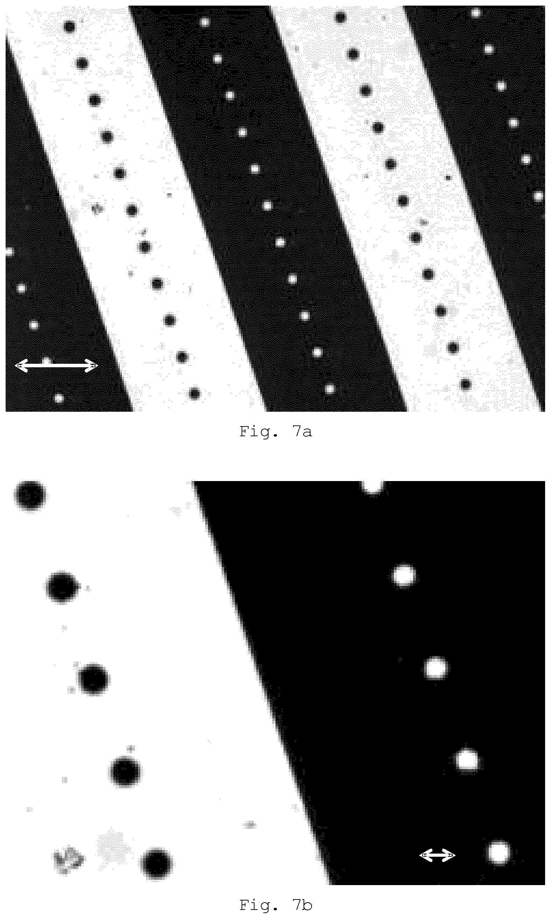

Die Figuren 5a, 5b, 6a, 6b, 7a und 7b zeigen die Einflüsse der Initiatorzusammensetzung auf die Qualität und Schärfe der erhaltenen Strukturen. Die Proben wurden jeweils gleich behandelt. Allerdings wurden für die Initiatorzusammensetzungen unterschiedliche Arten von photokatalytischem TiO₂ verwendet. So wurden zum einen TiO₂-Nanopartikel analog zu den in der Schrift US 2009/0269510 A1 verwendeten Partikeln hergestellt (lyo-TiO₂). Die Figuren 6a und 6b zeigen die Ergebnisse für "TiO₂-Nanoflakes" aus Anatas-TiO₂ mit einer Dicke von 1-5 nm und einer lateralen Ausdehnung < 20 nm. Außerdem wurden in einem Versuch TiO₂-Nanostäbe verwendet. Für alle Versuche wurden die gleichen Mengen in Gew.-% verwendet und unter identischen Bedingungen beschichtet und belichtet.

Die erfindungsgemäßen Nanostäbe führen zu einer deutlichen Verbesserung der Schärfe der Metallabscheidung. Selbst feine Strukturen von unter 10 µm konnten deutlich aufgelöst werden. Dabei handelt es sich sowohl um Silberpunkte als auch um nicht beschichtete Punkte innerhalb einer Silberfläche. Die Strukturen sind insbesondere deutlich schärfer als die Strukturen mit den Partikeln aus US 2009/0269510 A1.

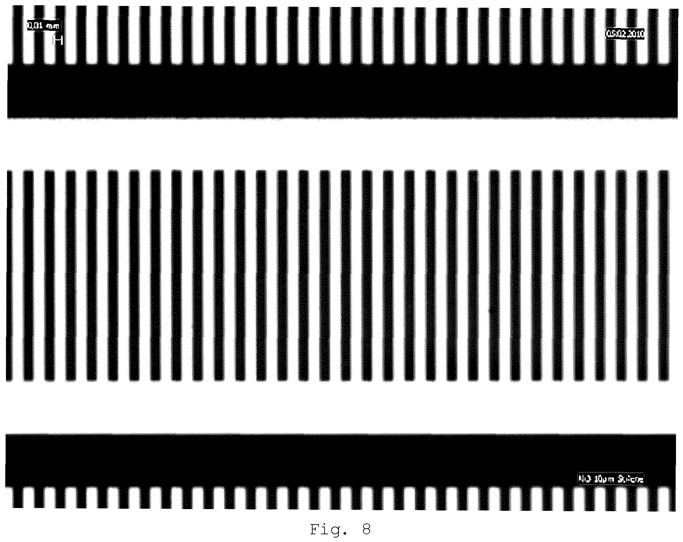

Figur 8 zeigt einen weiteren Ausschnitt aus der durch die Maske belichteten Struktur. Jede der schmalen Linien hat eine Breite von nur 10 µm. Dies zeigt die hohe Auflösung des erfindungsgemäßen Verfahrens.

Es sind zahlreiche Abwandlungen und Weiterbildungen der beschriebenen Ausführungsbeispiele verwirklichbar.

### Beispiele

### (1) Verwendete Substrate

Als Substrate wurden verschiedene Folien und Gläser verwendet. So wurden als Folien Polyethylenterephthalatfolien oder Polyimidfolien und als Gläser Natronkalkglas oder Borsilikatglas verwendet. Die Größe der Substrate variierte zwischen 5 cm x 5 cm und 10 cm x 10 cm. Die Dicke der Substrate variierte zwischen 0,075 mm bis 5 mm.

### (2) Herstellung der Nanostäbe

Vorschrift entnommen aus: Jia, Huimin at al., Materials Research Bulletin, 2009, 44, 1312-1316, "Nonaqueous sol-gel synthesis and growth mechanism of single crystalline TiO2 nanorods with high photocatalytic activity".

240 mL Benzylalkohol wurden in einer 500-ml-Schottflasche mit Stabrührmaus vorgelegt. Anschließend wurde "Alles" (Benzylalkohol, Spritze, Titantetrachlorid) in eine Glovebag unter Argon eingeschleust, die Benzylalkoholflasche geöffnet und unter starkem Rühren wurde der Bag 2mal mit Argon gespült (= mit Ar gefüllt und teilweise entleert und erneut befüllt). Mittels 20ml-Spritze und langer Kanüle wurden 12 ml TiCl₄ entnommen, die Kanüle von der Spritze entfernt und unter starkem Rühren tropfenweise zu dem Benzylalkohol gegeben.

Mit jedem zugegebenen Tropfen TiCl₄ ertönte ein Knall- bzw. Knackgeräusch und es war eine starke Rauchentwicklung zu beobachten. Dabei färbte sich die Lösung intensiv rot und erwärmte sich. Nach vollständiger Zugabe war die Lösung intensiv orange-gelb gefärbt und es hatten sich rote Agglomerate gebildet. Der Ansatz wurde noch für ∼ 1 h unter Ar-Atmosphäre mit offenem Deckel rühren gelassen und dann aus dem Glovebag herausgeholt. Die Lösung war nun intensiv gelb gefärbt mit mehreren kleinen und dickeren, weißen/hellen Agglomeraten.

Unter dem Abzug wurde der Ansatz offen dann noch für ∼ 1 h rühren gelassen bis er ohne die dickeren Klumpen in zwei Teflongefäße aufgeteilt (jeweils ∼ 130 g) und autoklaviert wurde (Druckaufschluss: in Block A; Zeit: 2 x 23 h 59 min; Temp.: 80 °C).

Der Überstand in beiden Teflongefäßen wurde mittels Pipette abgenommen, der gelige, weiße Niederschlag aufgeschlämmt und in Zentrifugenröhrchen gefüllt und abzentrifugiert (15 min; mit 2000 RCF; bei RT; Bremsleistung: 0). Das Zentrifugat wurde dekantiert und zu den Rückständen Chloroform gegeben. Die Ansätze wurden über Nacht stehen gelassen.

Die Zentrifugenröhrchen wurden mit Chloroform paarweise austariert, ordentlich geschüttelt bis keine größeren Agglomerate mehr zu sehen waren und abzentrifugiert (15 min; 3000 RCF; RT; Bremsleistung: 0). Das Zentrifugat wurde wieder dekantiert und es wurde erneut Chloroform zu den Rückständen gegeben. Anschließend wurde wie oben beschrieben weiterverfahren (ohne das Stehenlassen über Nacht). Insgesamt wurden die Partikel 3mal mit Chloroform gewaschen.

Nach dem letzten Dekantieren wurden die Zentrifugenröhrchen offen über Nacht unter dem Abzug stehen gelassen und am nächsten Morgen die getrockneten Nanostäbe in ein Rollrandglas umgefüllt.

### (3) Herstellung der Silberkomplex-Lösung

0,1284 g (1,06 mmol) TRIS (Tris(hydroxymethyl)aminomethan) wurde in 0,5 g (27,75 mmol) deionisiertem H₂O und 0,5 g (10,85 mmol) EtOH gelöst. Außerdem wurden 0,0845 g (0.5 mmol) AgNO₃ in 0,5 g (27,75 mmol) deionisiertem H₂O und 0,5 g (10,85 mmol) EtOH gelöst. Die AgNO₃-Lösung wurde unter Rühren zu der ersten Lösung gegeben. Die gebildete Lösung des Metallkomplexes war farblos und klar. Die Lösung kann auch in reinem deionisiertem Wasser hergestellt werden.

### (4) Herstellung einer Goldkomplex-Lösung

0,1926 g (1,59 mmol) TRIS (Tris(hydroxymethyl)-aminomethan) wurde in 0,5 g (27,75 mmol) deionisiertem H₂O und 0,5 g (10,85 mmol) EtOH gelöst. Außerdem wurden 0,1517 g (0,5 mmol) AuCl₃ oder 0,1699 g (0,5 mmol) HAuCl₄ in 0,5 g (27,75 mmol) deionisiertem H₂O und 0,5 g (10,85 mmol) EtOH gelöst. Die AuCl₃- oder HAuCl₄-Lösung wurde zu der Lösung des Liganden unter Rühren gegeben. Die gebildete Komplexlösung war farblos bis gelblich und klar. Die Lösung kann auch in reinem deionisierten Wasser hergestellt werden.

### (5) Lyothermale Synthese von TiO₂-Partikeln (lyo-TiO₂)

48,53 Ti(O-i-Pr)₄ wurden zu 52,73 g 1-PrOH (n-Propanol) gegeben. Zu dieser Lösung wurde langsam eine Lösung aus Salzsäure (37 %, 3,34 g) und 10,00 g 1-PrOH zugetropft. Zu dieser Lösung wurde dann eine Mischung aus 4,02 g H₂O und 20,00 g 1-PrOH getropft. Die erhaltene Lösung ist eventuell leicht gelb gefärbt und wurde in ein Druckaufschlussgefäß gefüllt (ca. 130 g). In diesem Gefäß wurde die Lösung für 2,5 h bei 210 °C behandelt.

Der Ansatz wurde Dekantiert und die erhaltenen Partikel in einen Kolben überführt und das Lösungsmittel bei 40 °C im Rotationsverdampfer bei Unterdruck entfernt.

Die erhaltenen Partikel wurden zur weiteren Verwendung in Wasser suspendiert.

### (6) Allgemeine Anwendung

Die folgenden Schritte wurden für jede Probe durchgeführt. Die Substrate wurden mit Ethanol, Propanol und flusenfreien Tüchern vorgereinigt. Die verschiedenen Suspensionen wurden entweder durch Fluten oder durch Rakeln aufgetragen. Die erhaltenen TiO₂-Schichten wurden in einem Ofen bei Temperaturen zwischen 100 °C und 150 °C, insbesondere bei 120 °C oder 140 °C, für 5 bis 30 Minuten getrocknet. Danach wurden die Substrate mit deionisiertem Wasser gespült, um Rückstände zu entfernen, und mit Druckluft getrocknet.

Danach wurde die Lösung des Silberkomplexes aufgetragen und mit UV-Strahlung bestrahlt. Danach wurde der überschüssige Silberkomplex durch Spülen mit deionisiertem Wasser entfernt und die beschichteten Substrate mit Druckluft getrocknet. Als Lichtquelle wurde eine Quecksilber-Xenon-Lampe (LOT-Oriel solar simulator, 1000 W, fokussiert auf eine Fläche von 10 cm x 10 cm) verwendet. Die Intensität der Lampe wurde mit dem digitalen Messgerät "UV-Integrator" (BELTRON) gemessen und betrug 55 mW/cm² in dem Spektralbereich von 250 bis 410 nm.

### (7) Suspensionen von TiO₂-Nanostäben in H₂O/EtOH

Zuerst wurden die TiO₂-Nanostäbe in deionisiertem Wasser suspendiert. Danach wurde eine entsprechende Menge an Ethanol hinzugefügt. In allen Suspensionen betrug das Verhältnis an H₂O und EtOH in den Suspensionen H₂O:EtOH → 20:80 in Gew.-% oder 10:90 in Gew.-%. Für die Herstellung von TiO₂-Schichten wurden folgende Suspensionen hergestellt:
- 2,5 Gew.-% TiO₂-Nanostäbe in H₂O/EtOH
- 2,0 Gew.-% TiO₂-Nanostäbe in H₂O/EtOH
- 1,5 Gew.-% TiO₂-Nanostäbe in H₂O/EtOH
- 1,0 Gew.-% TiO₂-Nanostäbe in H₂O/EtOH

### (8) MPTS als Grundierung

Die Qualität der TiO₂-Schichten, insbesondere auf den Folien, konnte durch vorheriges Aufbringen einer Beschichtung aus MPTS (Methacryloxypropyltrimethoxysilan) deutlich verbessert werden. Dazu wurde eine solche Schicht vor den TiO₂-Schichten aufgetragen. Die Substrate wurden durch Fluten mit einer 1.0 gew.-%ige MPTS-Lösung in Butylacetat beschichtet. Die MPTS-Schicht wurde photochemisch gehärtet. Danach wurde die TiO₂-Schicht aufgetragen, wie unter (6) beschrieben.

### (9) Plasmabehandlung

Außerdem wurde gefunden, dass die Qualität der TiO₂-Schichten, insbesondere auf Folien, durch eine Vorbehandlung mit Plasma verbessern lässt. Die gesäuberten Substrate wurden mit einem 600 Watt Sauerstoffplasma für 1,5 Minuten behandelt. Danach wurde die TiO₂-Schicht aufgetragen, wie unter (6) beschrieben.

### (10) Flammenbehandlung der Foliensubstrate

Eine Verbesserung der Benetzung von Foliensubstraten mit der Suspension der TiO₂-Nanostäbe konnte durch vorherige Flammenbehandlung mit Silan erreicht werden. Dafür wurden die gereinigten Foliensubstrate für wenige Sekunden bei einem Abstand von ca. 15 cm mit einer Flamme behandelt. Danach wurde die TiO₂-Schicht aufgetragen, wie unter (6) beschrieben.

### (11) Aufbringen der TiO₂-Schicht auf eine poröse SiO₂-Schicht

Die Suspension von TiO₂-Nanostäben wurde durch Fluten auf eine poröse SiO₂-Schicht auf Glas aufgebracht. Dafür wurde ein übliches SiO₂-Sol verwendet.

### (12) Suspensionen von TiO₂-Nanostäben mit H-Sol

Zunächst wurde ein H-Sol hergestellt. Dies ist eine gelbe Lösung, welche amorphes Titandioxid enthält. Dazu wurden 396,2 g (1,39 mol) Ti(O-i-Pr)₄ [CAS: 546-68-9] zu 2869,2 g 2-Propanol gegeben. 139,3 g (1,39 mol) Acetylaceton [CAS: 123-54-6] wurden unter Rühren zugegeben. Die Mischung wurde 15 Minuten bei Raumtemperatur gerührt. Zu der Mischung wurde eine Lösung aus 38,7 g Wasser und 92,64 g HCl 37 % [CAS: 7647-01-0] langsam hinzugegeben. Die Mischung wurde bei Raumtemperatur für 24 Stunden gerührt und bei 4 °C gelagert. Das Gesamtvolumen der Mischung beträgt ungefähr 4,5 l. Um die Benetzungsfähigkeit der Suspensionen zu verbessern wurde H-Sol zu einer Suspension von TiO₂-Nanostäben gegeben. Die Menge an H-Sol ist auf die Masse an verwendeter Suspension bezogen. Folgende Mischungen wurden hergestellt:
- (1,5 Gew.-% TiO₂-Suspension) + 13 Gew.-% H-Sol
- (1,5 Gew.-% TiO₂-Suspension) + 15 Gew.-% H-Sol
- (1,0 Gew.-% TiO₂-Suspension) + 6.5 Gew.-% H-Sol
- (1,0 Gew.-% TiO₂-Suspension) + 10 Gew.-% H-Sol
- (0,5 Gew.-% TiO₂-Suspension) + 2,5 Gew.-% H-Sol
- (0,5 Gew.-% TiO₂-Suspension) + 5,0 Gew.-% H-Sol

Die Zusammensetzungen wurden auf gereinigte PET-Folie durch Fluten aufgetragen. Nach Trocknung bei 120 °C für ca. 10 Minuten wurden leicht trübe Schichten erhalten.

Die erhaltenen Mischungen wurden wie unter (6) beschrieben aufgetragen.

### (13) TiO₂-Nanostäbe im GTI-Sol-System

GTI ist ein wasserbasiertes Solsystem, welches im Wesentlichen auf (3-Glycidyloxypropyl)triethoxysilan (GPTES) und Titan(IV)isopropoxid basiert. Zur Herstellung werden in einem 250ml - Einhalskolben wird das GPTES vorgelegt (4 mol, z.B. 58,922 g). Anschließend werden Titanisopropylat (1 mol, z.B. 15,037 g) und Eisessig (4 mol, z.B. 12,708 g) unter Rühren zugegeben. Nach Homogenisierung erfolgt die Zugabe von Wasser (14 mol, H₂O bzw. Partikelsuspension, z.B. 13,333 g H₂O). Dabei beginnt der Ansatz zu gelieren, dennoch wird die gesamte Wassermenge zugegeben. Der Ansatz wird auf dem Rührer stehen gelassen und nach einiger Zeit wieder flüssig. Die Mol-Angaben dienen zur Verdeutlichung der Verhältnisse. Eventuelle Partikel- oder Nanodraht-Suspensionen werden anstelle des Wassers in entsprechender Menge zugegeben.

Die TiO₂-Nanostäbe wurden während der Herstellung zu dem Sol gegeben, so dass die TiO₂-Nanostäbe ca. 60 Gew.-% des Feststoffgehalts der Beschichtungszusammensetzung ausmachen. Da das erhaltene Sol etwas viskos war, wurde es mit der Rakel aufgetragen. Außerdem wurde in einigen Zusammensetzungen das das GTI-Sol mit Ethanol 1/3 bis 1/5 verdünnt.

Das Titan(IV)isopropoxid kann auch durch TEOS oder MTEOS oder eine Mischung aus beiden substituiert werden. So kann eine ganze Reihe unterschiedlicher Zusammensetzung erhalten werden.

### Suspensionen von TiO₂-Nanostäben mit GTI-Sol mit TiO₂-Nanostäben

Das GTI-Sol mit den TiO₂-Nanostäben wurde gemäß der Masse der Suspension zu der Suspension von TiO₂-Nanostäben gegeben. Folgende Mischungen wurden hergestellt:
- (1,5 Gew.-% TiO₂-Nanostäbesuspension) + 5 Gew.-% GTI (60 Gew.-% TiO₂-Nanostäbe)
- (1,5 Gew.-% TiO₂-Nanostäbesuspension) + 10 Gew.-% GTI (60 Gew.-% TiO₂- Nanostäbe)
- (1,5 Gew.-% TiO₂-Nanostäbesuspension) + 20 Gew.-% GTI (60 Gew.-% TiO₂- Nanostäbe)

Die erhaltenen Mischungen wurden wie unter (6) beschrieben aufgetragen.

### (14) Suspensionen von TiO₂-Nanostäben mit GTI-Sol und TiO₂-Nanopartikeln.

Für die Herstellung dieser Beschichtungszusammensetzungen wurde zum dem GTI-Sol während der Herstellung Titandioxid-Nanopartikel (lyo-TiO₂ mit einer Größe zwischen 7 bis 10 nm) hinzugefügt. Der Gehalt an TiO₂-Nanopartikeln in dem GTI-Sol betrug zwischen 20 Gew.-% bis 95 Gew.-%, bevorzugt 30 Gew.-% oder 60 Gew.-%. Das hergestellte Sol wurde zu den Suspensionen von TiO₂-Nanostäben bezogen auf die Masse der Suspension gegeben. Folgende Mischungen wurden hergestellt:
- (1,5 Gew.-% TiO₂-Nanostäbesuspension) + 10 Gew.-% GTI (30 Gew.-% TiO₂-Nanopartikel)
- (1,5 Gew.-% TiO₂-Nanostäbesuspension) + 5 Gew.-% GTI (30 Gew.-% TiO₂-Nanopartikel)
- (1,5 Gew.-% TiO₂-Nanostäbesuspension) + 10 Gew.-% GTI (60 Gew.-% TiO₂-Nanopartikel)

Die erhaltenen Mischungen wurden wie unter (6) beschrieben aufgetragen.

### (15) Suspensionen von TiO₂-Nanostäben mit DEG / MEG

Zu den Suspensionen von TiO₂-Nanostäben wurde auch DEG (Diethylenglycol), beziehungsweise MEG (Monoethylenglycol), bezogen auf die Masse an verwendeter Suspension gegeben. Folgende Mischungen wurden hergestellt:
- (1,5 Gew.-% TiO₂-Nanostäbesuspension) + 4,0 Gew.-% DEG
- (1,5 Gew.-% TiO₂-Nanostäbesuspension) + 3,5 Gew.-% DEG
- (1,5 Gew.-% TiO₂-Nanostäbesuspension) + 3,0 Gew.-% DEG
- (1,5 Gew.-% TiO₂-Nanostäbesuspension) + 4,0 Gew.-% MEG
- (1,5 Gew.-% TiO₂-Nanostäbesuspension) + 3,0 Gew.-% MEG

Die erhaltenen Mischungen wurden wie unter (6) beschrieben aufgetragen.

### (16) Laminare Abscheidung von Silber

Die hergestellten TiO₂-Beschichtungen wurden mit deionisiertem Wasser gewaschen und mit Druckluft getrocknet. Danach wurde die Lösung mit dem Silberkomplex folgendermaßen aufgebracht: Ein elastischer Rahmen wurde auf das beschichtete Substrat gelegt und die Lösung mit dem Silberkomplex in dem Rahmen eingefüllt. Die Dicke der Flüssigkeitsschicht in dem Rahmen konnte in Abhängigkeit mit dem verwendeten Rahmen zwischen 30 µm und 2 mm variiert werden. Danach wurden die Substrate mit UV-Licht für eine Dauer zwischen 1 bis 5 Minuten bestrahlt. Der überschüssige Silberkomplex wurde mit deionisiertem Wasser weggewaschen und die Substrate getrocknet.

### (17) Herstellung von Silber-Mikrostrukturen

Die Substrate (z. B. Glas, PMMA, PET, PVC, PS, ...) wurden mit TiO₂-Nanostäben beschichtet. Die hergestellten TiO₂-Beschichtungen wurden mit deionisiertem Wasser gewaschen und mit Druckluft getrocknet. Es wurden transparente Beschichtungen erhalten. Danach wurde die beschichtete Oberfläche mit der Lösung mit dem Silberkomplex benetzt. Auf das Substrat wurde eine Quarzmaske mit einer Feinstruktur aufgebracht. Das Substrat wurde danach durch die Maske für 20 s bis 5 Minuten mit UV-Licht (z.B. LOT-Oriel solar simulator, 1000 W Hg(Xe)-Lichtquelle, fokussiert auf einer Fläche von 10x10 cm²) bestrahlt. Die Maske wurde entfernt und der überschüssige Silberkomplex durch Waschen entfernt. Danach wurden die Substrate getrocknet. Gegebenenfalls wurde eine weitere Schutzschicht aufgebracht oder auflaminiert. Mit diesem Prozess wurden Strukturen mit einer Auflösung von 10 µm erhalten.

### (18) Herstellung einer Silber-Mikrostruktur

Auf eine 0,075 mm dicke, vorgereinigte PET-Folie wurde durch Fluten mit einer Suspension mit 2,5 Gew.-% TiO₂-Nanostäben in H₂O/EtOH beschichtet. Das Verhältnis von H₂O und EtOH in der Suspension betrug 10 Gew.-% H₂O und 90 Gew.-% EtOH. Die erhaltene Schicht aus TiO₂ wurde in einem Ofen bei 120 °C für 30 Minuten getrocknet. Danach wurde das Substrat mit deionisiertem Wasser abgespült und mit Druckluft getrocknet. Die Lösung des Silberkomplexes wurde auf die Oberfläche getropft und eine Maske aus Quarzglas wurde auf das Substrat aufgebracht. Dabei betrug der Abstand Maske zur Oberfläche der Initiatorschicht, und damit die Schichtdicke der Vorläuferzusammensetzung, 200 µm. Danach wurde für 5 Minuten durch die Maske mit UV-Licht belichtet. Die Maske wurde entfernt und der überschüssige Silberkomplex abgewaschen. Danach wurde das Substrat getrocknet.

### (19) Messung der Leitfähigkeit von Beschichtungen

### Probe a)

Eine 2.0 mm dicke, gesäuberte Scheibe aus Borosilikatglas (5x5 cm²) wurde durch Fluten mit einer Suspension aus 1.5 wt% TiO₂-Nanostäben in H₂O/EtOH beschichtet. Das Verhältnis von H₂O und EtOH in der Suspension betrug 10 Gew.-% H₂O und 90 Gew.-% EtOH. Die erhaltene Schicht aus TiO₂ wurde in einem Ofen bei 120 °C für 20 Minuten getrocknet. Danach wurde das Substrat mit deionisiertem Wasser abgespült und mit Druckluft getrocknet. Danach wurde auf der Oberfläche flächig Silber abgeschieden. Ein elastischer Rahmen wurde auf die Beschichtung gelegt und die Lösung des Silberkomplexes in den Rahmen gefüllt. Die Höhe der Lösung im Rahmen betrug 2 mm. Danach wurde das Substrat für 1 Minute mit UV-Licht belichtet. Die überschüssige Silberkomplexlösung wurde mit deionisiertem Wasser abgewaschen und das beschichtete Substrat getrocknet.

### Probe b)

Eine 2.0 mm dicke, gesäuberte Scheibe aus Borosilikatglas (5x5 cm2) wurde durch Fluten mit einer Suspension aus 1.5 wt% TiO₂-Nanostäben in H₂O/EtOH beschichtet. Das Verhältnis von H₂O und EtOH in der Suspension betrug 10 Gew.-% H₂O und 90 Gew.-% EtOH. Die erhaltene Schicht aus TiO₂ wurde in einem Ofen bei 120 °C für 20 Minuten getrocknet. Danach wurde das Substrat mit deionisiertem Wasser abgespült und mit Druckluft getrocknet. Danach wurde auf der Oberfläche flächig Silber abgeschieden. Ein elastischer Rahmen wurde auf die Beschichtung gelegt und die Lösung des Silberkomplexes in den Rahmen gefüllt. Die Höhe der Lösung im Rahmen betrug 2 mm. Danach wurde das Substrat für 3 Minuten mit UV-Licht belichtet. Die überschüssige Silberkomplexlösung wurde mit deionisiertem Wasser abgewaschen und das beschichtete Substrat getrocknet.

### Probe c)

Eine 2.0 mm dicke, gesäuberte Scheibe aus Borosilikatglas (5x5 cm²) wurde durch Fluten mit einer Suspension aus 1.5 wt% TiO₂-Nanostäben mit 5 Gew.-% GTI-Sol (60 Gew.-% TiO₂-Nanostäbe) bezogen auf die Masse der TiO₂-Suspension beschichtet. Die erhaltene Schicht aus TiO₂ wurde in einem Ofen bei 120 °C für 20 Minuten getrocknet. Danach wurde das Substrat mit deionisiertem Wasser abgespült und mit Druckluft getrocknet. Danach wurde auf der Oberfläche flächig Silber abgeschieden. Ein elastischer Rahmen wurde auf die Beschichtung gelegt und die Lösung des Silberkomplexes in den Rahmen gefüllt. Die Höhe der Lösung im Rahmen betrug 2 mm. Danach wurde das Substrat für 1 Minute mit UV-Licht belichtet. Die überschüssige Silberkomplexlösung wurde mit deionisiertem Wasser abgewaschen und das beschichtete Substrat getrocknet.

### Probe d)

Eine 2.0 mm dicke, gesäuberte Scheibe aus Borosilikatglas (5x5 cm²) wurde durch Fluten mit einer Suspension aus 1.5 wt% TiO₂-Nanostäben mit 5 Gew.-% GTI-Sol (60 Gew.-% TiO₂-Nanostäbe) bezogen auf die Masse der TiO₂-Suspension beschichtet. Die erhaltene Schicht aus TiO₂ wurde in einem Ofen bei 120 °C für 20 Minuten getrocknet. Danach wurde das Substrat mit deionisiertem Wasser abgespült und mit Druckluft getrocknet. Danach wurde auf der Oberfläche flächig Silber abgeschieden. Ein elastischer Rahmen wurde auf die Beschichtung gelegt und die Lösung des Silberkomplexes in den Rahmen gefüllt. Die Höhe der Lösung im Rahmen betrug 2 mm. Danach wurde das Substrat für 3 Minuten mit UV-Licht belichtet. Die überschüssige Silberkomplexlösung wurde mit deionisiertem Wasser abgewaschen und das beschichtete Substrat getrocknet.

### Messung der Leitfähigkeit

Die Leitfähigkeit wurde mittels Vierpunktmessgerät jeweils an 5 verschiedenen Stellen der Ag-Schichten gemessen. Aus den Messwerten wurde anschließend der Mittelwert gebildet. Tabelle 1 zeigt die gemessenen Werte für einige Substrate. Die Zeitangabe bei der Silberschicht gibt die Dauer der Bestrahlung an. In den unterschiedlichen Spalten wurde der Einfluss der Dauer der Temperaturbehandlung der Initiatorschicht nach dem Auftragen und vor dem Auftragen der Vorläuferzusammensetzung. Die Dauer der Temperaturbehandlung führt zu einer leichten Verbesserung der Leitfähigkeit. Eine längere Bestrahlung, und damit wohl eine verbesserte Reduktion des Silberkomplexes, führt zu einer deutlichen Verbesserung der Leitfähigkeit. Die zweite Zeile gibt jeweils den Flächenwiderstand (pSHEET) an.

Durch die Verwendung von nur zwei Beschichtungslösungen konnte auf diese Weise ein Substrat mit einer für eine gute Leitfähigkeit ausreichende Menge an Silber beschichtet werden. Dies erlaubt auch die Anwendung des Verfahrens in einer kontinuierlichen Beschichtungsanlage für Folien.

**Tabelle 1**

| Probe | Messmodus | 0 min 120°C | 5 min 120°C | 10 min 120° C | 15 min 120° C | 25 min 120° C | 35 min 120° C | 50 min 120° C |
|---|---|---|---|---|---|---|---|---|
| a) Boros.glas ; 1,5% Nanostäbe; 1 min | pSHEET | 3,1096 Ω | 1,2606 Ω | 1,2154 Ω | 1,1888 Ω | 1,1178 Ω | 1,1998 Ω | 1,0646 Ω |
| | pV/I | 690,44 mΩ | 283,1 mΩ | 271,08 mΩ | 259,62 mΩ | 251,48 mΩ | 260,9 mΩ | 238,16 mΩ |
| b) Boros.glas ; 1,5% rods; 3 min | pSHEET | 2,3664 Ω | 850,98 mΩ | 782,72 mΩ | 753,16 mΩ | 723,42 mΩ | 728, 9 mΩ | 681,38 mΩ |
| | pV/I | 513,16 mΩ | 184,64 mΩ | 175,02 mΩ | 167,38 mΩ | 161,08 mΩ | 160,5 mΩ | 147,2 mΩ |
| | | | | | | | | |
| c) Boros.glas ; 1,5% Nanostäbe+ GTI; 1 min | pSHEET | 9,4432 Ω | 3,012 Ω | 3,013 Ω | 2,9076 Ω | 2,9938 Ω | 3,205 Ω | 3,0704 Ω |
| | pV/I | 2,0688 Ω | 697,6 mΩ | 658,7 mΩ | 699,32 mΩ | 654,3 mΩ | 706,5 mΩ | 705,66 mΩ |
| d) Boros.glas ; 1,5% Nanostäbe+ GTI; 3 min | pSHEET | 2,9536 Ω | 825,28 mΩ | 794,54 mΩ | 768,9 mΩ | 736,22 mΩ | 743,12 mΩ | 691,76 mΩ |
| | pV/I | 651,7 mΩ | 183,82 mΩ | 174,02 mΩ | 168,2 mΩ | 160,88 mΩ | 165,04 mΩ | 152,86 mΩ |

### Bezugszeichen

- 40: UV-Licht
- 42: Maske
- 44: Vorläuferzusammensetzung
- 46: Initiatorschicht
- 48: Substrat

### zitierte Literatur

US 5,534,312
US 2004/0026258 A1
US 2005/0023957 A1
US 2006/0144713 A1

Noh, C.-, et al., Advances in Resist Technology and Processing XXII, Proceedings of SPIE, 2005, 5753, 879-886, "A novel patterning method of low-resistivity metals".

Noh, C.-, et al., Chemistry Letters, 2005, 34(1), 82-83, "A novel patterning method of low-resistivity metals".

US 2009/0269510 A1

Jia, Huimin at al., Materials Research Bulletin, 2009, 44, 1312-1316, "Nonaqueous sol-gel synthesis and growth mechanism of single crystalline TiO2 nanorods with high photocatalytic activity".

## Patentansprüche

1. Verfahren zur Herstellung von metallischen Strukturen umfassend die folgenden Schritte:
(a) Auftragen einer Initiatorzusammensetzung auf ein Substrat zur Bildung einer Initiatorschicht, wobei die Zusammensetzung als Initiator photokatalytisch aktive Nanostäbe umfasst, wobei die Nanostäbe einen Durchmesser von unter 100 nm und eine Länge von unter 500 nm aufweisen;
(b) Auftragen einer Vorläuferzusammensetzung umfassend mindestens eine Vorläuferverbindung für eine Metallschicht auf das Substrat;
(c) Reduktion der Vorläuferverbindung zum Metall durch Einwirkung von elektromagnetischer Strahlung auf den Initiator, wobei eine Metallschicht mindestens in einem Bereich der Oberfläche der Initiatorschicht aufgebracht wird;
wobei in Schritt (a) und/oder in Schritt (b) und/oder in Schritt (c) eine Strukturierung erfolgt.

2. Verfahren nach Anspruch 1, **dadurch gekennzeichnet, dass** die Strukturierung Strukturen mit einer minimalen lateralen Ausdehnung von unter 500 µm umfasst.

3. Verfahren nach einem der vorhergehenden Ansprüche, **dadurch gekennzeichnet, dass**
die Vorläuferverbindung ein Silber-, Gold oder Kupferkomplex ist.

4. Verfahren nach einem der vorhergehenden Ansprüche, **dadurch gekennzeichnet, dass**
vor dem Auftragen der Initiatorzusammensetzung die Oberfläche des Substrats vorbehandelt wird, wobei die Vorbehandlung eine Plasmabehandlung, Koronabehandlung, Flammenbehandlung und/oder das Auftragen und Härten einer organisch-anorganischen Beschichtung umfasst.

5. Verfahren nach einem der vorherigen Ansprüche, **dadurch gekennzeichnet, dass**
die Initiatorzusammensetzung eine matrixbildende Komponente umfasst.

6. Verfahren nach einem der vorherigen Ansprüche, **dadurch gekennzeichnet, dass**
die Initiatorzusammensetzung mindestens eine Verbindung mit mindestens 2 polaren Gruppen enthält.

7. Beschichtetes Substrat erhalten durch das Verfahren nach einem der Ansprüche 1 bis 6.

8. Beschichtetes Substrat nach Anspruch 7, **dadurch gekennzeichnet, dass**
das beschichtete Substrat eine Initiatorschicht mit einer Dicke zwischen 50 nm bis 200 µm ist, welche photokatalytisch aktive Nanostäbe umfasst, und auf der mindestens in einem Bereich der Oberfläche, eine Metallschicht aufgebracht ist.

9. Beschichtetes Substrat nach einem der Ansprüche 7 oder 8, **dadurch gekennzeichnet, dass**
das beschichtete Substrat und die metallischen Strukturen mindestens teilweise transparent erscheinen.

10. Verwendung eines Substrats nach einem der Ansprüche 7 bis 9 als Leiterbahn in elektronischen Anwendungen, in Touch-Screen-Displays, in Solarkollektoren, in Displays, als RFID-Antenne oder in Transistoren.

## Claims

1. Process for producing metallic structures, comprising the following steps:
(a) applying an initiator composition to a substrate to form an initiator layer, where the composition comprises photocatalytically active nanorods as an initiator, where the nanorods having a diameter of less than 100 nm and a length of less than 500 nm;
(b) applying a precursor composition comprising at least one precursor compound for a metal layer to the substrate;
(c) reducing the precursor compound to the metal by the action of electromagnetic radiation on the initiator, where a metal layer is applied at least in one region of the surface of the initiator layer; wherein a structuring operation is effected in step (a) and/or in step (b) and/or in step (c).

2. Process according to Claim 1, **characterized in that**
the structuring comprises structures having a minimum lateral dimension of less than 500 µm.

3. Process according to either of the preceding claims, **characterized in that**
the precursor compound is a silver, gold or copper complex.

4. Process according to any of the preceding claims, **characterized in that**
the application of the initiator composition is preceded by pretreatment of the surface of the substrate, said pretreatment comprising a plasma treatment, corona treatment, flame treatment and/or the application and curing of an organic-inorganic coating.

5. Process according to any of the preceding claims, **characterized in that**
the initiator composition comprises a matrix-forming component.

6. Process according to any of the preceding claims, **characterized in that**
the initiator composition comprises at least one compound having at least 2 polar groups.

7. Coated substrate obtained by the process according to any of Claims 1 to 6.

8. Coated substrate according to Claim 7, **characterized in that**
the coated substrate is an initiator layer which has a thickness of between 50 nm to 200 µm and comprises photocatalytically active nanotubes, and to which, at least in one region of the suface, a metal layer has been applied.

9. Coated substrate according to either of Claims 7 and 8,
**characterized in that**
the coated substrate and the metallic structures have an at least partly transparent appearance.

10. Use of a substrate according to any of Claims 7 to 9 as a conductor track in electronic applications, in touchscreen displays, in solar collectors, in displays, as an RFID antenna or in transistors.

## Revendications

1. Procédé de fabrication de structures métalliques comprenant les étapes suivantes :
(a) l'application d'une composition d'initiateur sur un substrat pour la formation d'une couche d'initiateur, la composition comprenant en tant qu'initiateur des nanotiges photocatalytiquement actives, les nanotiges présentant un diamètre inférieur à 100 nm et une longueur inférieure à 500 nm ;
(b) l'application d'une composition de précurseur comprenant au moins un composé précurseur pour une couche métallique sur le substrat ;
(c) la réduction du composé précurseur en le métal par l'action d'un rayonnement électromagnétique sur l'initiateur, une couche métallique étant appliquée au moins dans une zone de la surface de la couche d'initiateur ;
une structuration ayant lieu à l'étape (a) et/ou à l'étape (b) et/ou à l'étape (c).

2. Procédé selon la revendication 1, **caractérisé en ce que** la structuration comprend des structures ayant une dimension latérale minimale inférieure à 500 µm.

3. Procédé selon l'une quelconque des revendications précédentes, **caractérisé en ce que** le composé précurseur est un complexe d'argent, d'or ou de cuivre.

4. Procédé selon l'une quelconque des revendications précédentes, **caractérisé en ce que** la surface du substrat est prétraitée avant l'application de la composition d'initiateur, le prétraitement comprenant un traitement plasma, un traitement corona, un traitement à la flamme et/ou l'application et le durcissement d'un revêtement organique-inorganique.

5. Procédé selon l'une quelconque des revendications précédentes, **caractérisé en ce que** la composition d'initiateur comprend un composant formant une matrice.

6. Procédé selon l'une quelconque des revendications précédentes, **caractérisé en ce que** la composition d'initiateur contient au moins un composé contenant au moins 2 groupes polaires.

7. Substrat revêtu obtenu par le procédé selon l'une quelconque des revendications 1 à 6.

8. Substrat revêtu selon la revendication 7, **caractérisé en ce que** le substrat revêtu est une couche d'initiateur d'une épaisseur comprise entre 50 nm et 200 µm, qui comprend des nanotiges photocatalytiquement actives, et sur laquelle une couche métallique est appliquée au moins dans une zone de la surface.

9. Substrat revêtu selon l'une quelconque des revendications 7 ou 8, **caractérisé en ce que** le substrat revêtu et les structures métalliques apparaissent au moins partiellement transparents.

10. Utilisation d'un substrat selon l'une quelconque des revendications 7 à 9 en tant que piste conductrice dans des applications électroniques, dans des écrans tactiles, dans des collecteurs solaires, dans des écrans, en tant qu'antenne RFID ou dans des transistors.
